# EUROPEAN PATENT APPLICATION

(11) **EP 4 043 523 A1**
(43) Date of publication of application: **17.08.2022**
(21) Application number: 20873964.9
(22) Date of filing: 30.09.2020
(51) Int. Cl.: C08L 33/02, C08F 2/44, G02B 5/20

(54) **COLORED CURABLE RESIN COMPOSITION**

(30) Priority: 07.10.2019 JP 2019184819
(71) Applicant: Sumitomo Chemical Company, Limited, Chuo-ku Tokyo 103-6020 (JP)
(72) Inventor: AKASAKA, Tetsuo, Osaka-shi, Osaka 554-8558 (JP); INOUE, Katsuharu, Osaka-shi, Osaka 554-8558 (JP); AOKI, Takuma, Osaka-shi, Osaka 554-8558 (JP); KAWANISHI, Yutaka, Osaka-shi, Osaka 554-8558 (JP)
(74) Representative: Vossius & Partner Patentanwälte Rechtsanwälte mbB
(86) International application number: PCT/JP2020/037082
(87) International publication number: WO 2021/070693

(57) **Abstract**

An object of the present invention is to provide a colored curable resin composition for forming an optical filter in which the occurrence of foreign matter is reduced. The present invention relates to a colored curable resin composition containing a colorant, a resin, a polymerizable compound, and a polymerization initiator, wherein the colorant is a colorant containing a compound represented by formula (I) or formula (II).

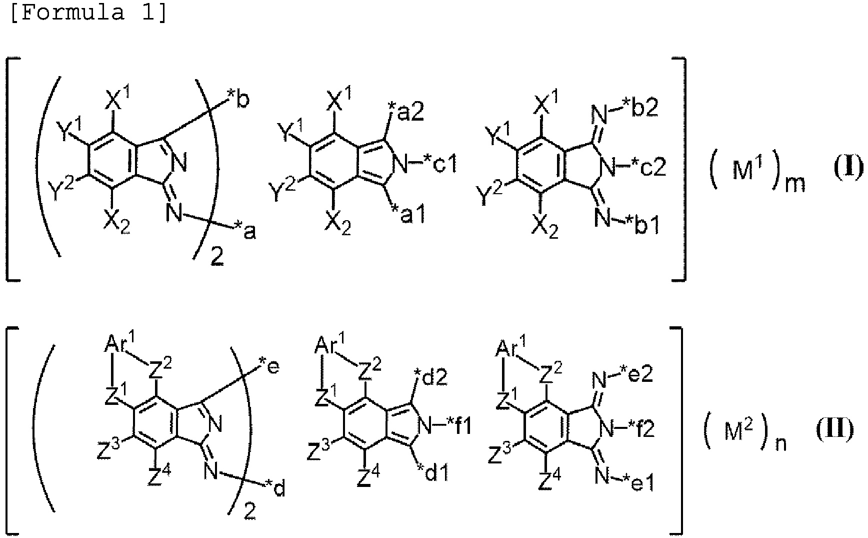

## Description

### Technical Field

The present invention relates to a colored curable resin composition, an optical filter, and a solid-state image sensor.

### Background Art

An optical filter used for display devices such as a liquid crystal display device, an electroluminescence display device, and a plasma display, and solid-state image sensors such as a CCD and a CMOS sensor is produced from a colored curable resin composition. A composition containing a phthalocyanine compound as a colorant has been known as the colored curable resin composition (Patent Literature 1). As described in Patent Literature 1, the composition absorbs near-infrared ray, to allow the formation of a fine pattern.

### Citation List

### Patent Literature

Patent Literature 1: Japanese Patent Laid-Open No. 2010-160380

### Summary of Invention

### Technical Problem

An object of the present invention is to provide a colored curable resin composition for forming an optical filter in which the occurrence of foreign matter is reduced.

### Solution to Problem

The present invention includes the following inventions.
[1] A colored curable resin composition comprising a colorant, a resin, a polymerizable compound, and a polymerization initiator, wherein the colorant is a colorant comprising a compound represented by formula (I) or formula (II). 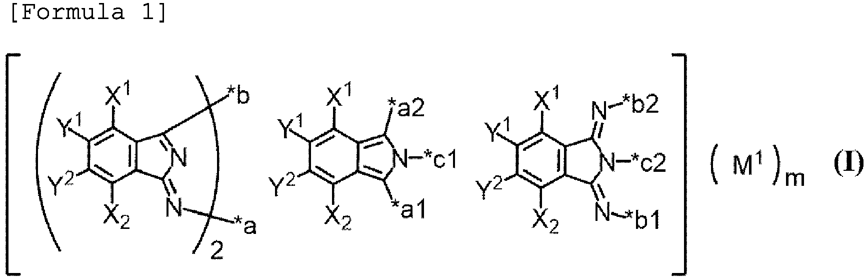 wherein:
   X¹ and X² each independently represent a hydrogen atom, SR¹, or NR²R³;
   Y¹ and Y² each independently represent a hydrogen atom, OR¹, or SR¹;
   R¹ represents an aryl group having 6 to 20 carbon atoms or a heteroaryl group having 3 to 20 carbon atoms, and a hydrogen atom contained in the aryl group and the heteroaryl group is optionally replaced with a halogen atom or an alkoxy group having 1 to 20 carbon atoms;
   R² and R³ each independently represent a hydrogen atom or an alkyl group having 1 to 10 carbon atoms; a methylene group contained in the alkyl group is optionally replaced with an oxygen atom; and R² and R³ are optionally bonded to each other to form a nitrogen atom-containing ring;
   a plurality of X¹, X², Y¹, Y², R¹, R², or R³, when present in one molecule, are optionally the same or different from each other;
   M¹ represents a hydrogen atom, a monovalent metal atom, a divalent metal atom, a trivalent substituted metal atom, a tetravalent substituted metal atom, or an oxidized metal atom;
   when M¹ is the hydrogen atom or the monovalent metal atom, m is 2; and when M¹ is the divalent metal atom, the trivalent substituted metal atom, the tetravalent substituted metal atom, or the oxidized metal atom, m is 1;
   all of *a, *a1, *a2, *b, *b1, *b2, *c1, and *c2 represent a bond; one of two *a is bonded to *a1, and the other is bonded to *a2; one of two *b is bonded to *b1,
   and the other is bonded to *b2; and *c1 and *c2 are bonded to M¹; 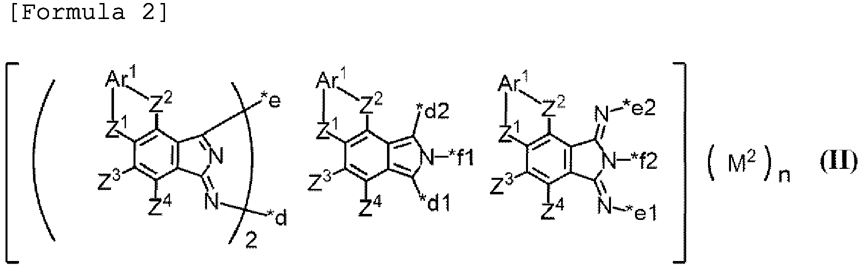 wherein:
      Z¹ and Z² each independently represent an oxygen atom, a sulfur atom, or NR⁴;
      R⁴ represents a hydrogen atom or an alkyl group having 1 to 10 carbon atoms, and a methylene group contained in the alkyl group is optionally replaced with an oxygen atom;
      Ar¹ represents an arylene group having 6 to 20 carbon atoms or a heteroarylene group having 3 to 20 carbon atoms, and a hydrogen atom contained in the arylene group and the heteroarylene group is optionally replaced with a halogen atom or an alkoxy group having 1 to 20 carbon atoms;
      Z³ and Z⁴ each independently represent a hydrogen atom, N(R⁶)₂, OR⁵, or SR⁵;
      R⁵ represents an alkyl group having 1 to 20 carbon atoms, an aryl group having 6 to 20 carbon atoms, or a heteroaryl group having 3 to 20 carbon atoms; a hydrogen atom contained in the alkyl group is optionally replaced with a halogen atom; a methylene group contained in the alkyl group is optionally replaced with an oxygen atom; and a hydrogen atom contained in the aryl group and the heteroaryl group is optionally replaced with a halogen atom or an alkoxy group having 1 to 20 carbon atoms;
      R⁶ represents a hydrogen atom or an alkyl group having 1 to 10 carbon atoms, wherein a hydrogen atom contained in the alkyl group is optionally replaced with an aryl group having 6 to 10 carbon atoms, and wherein a methylene group contained in the alkyl group is optionally replaced with an oxygen atom;
      a plurality of Z¹, Z², Z³, Z⁴, Ar¹, R⁴, R⁵, or R⁶, when present in one molecule, are optionally the same or different from each other;
      M² represents a hydrogen atom, a monovalent metal atom, a divalent metal atom, a trivalent substituted metal atom, a tetravalent substituted metal atom, or an oxidized metal atom;
      when M² is the hydrogen atom or the monovalent metal atom, n is 2, and when M² is the divalent metal atom, the trivalent substituted metal atom, the tetravalent substituted metal atom, or the oxidized metal atom, n is 1; and
      all of *d, *d1, *d2, *e, *e1, *e2, *f1, and *f2 represent a bond; one of two *d is bonded to *d1, and the other is bonded to *d2; one of two *e is bonded to *e1, and the other is bonded to *e2; and *f1 and *f2 are bonded to M².
[2] The colored curable resin composition according to [1], wherein the resin is a copolymer having a structural unit derived from at least one selected from the group consisting of an unsaturated carboxylic acid and an unsaturated carboxylic anhydride and a structural unit having a cyclic ether structure having 2 to 4 carbon atoms and an ethylenically unsaturated bond.
[3] An optical filter formed from the colored curable resin composition according to [1] or [2].
[4] A solid-state image sensor comprising the optical filter according to [3].

### Advantageous Effects of Invention

According to a colored curable resin composition of the present invention, when an optical filter is formed, foreign matter is less likely to occur.

### Description of Embodiments

A colored curable resin composition of the present invention contains a colorant (hereinafter, sometimes referred to as colorant (A)), a resin (hereinafter, sometimes referred to as resin (B)), a polymerizable compound (hereinafter, sometimes referred to as polymerizable compound (C)), and a polymerization initiator (hereinafter, sometimes referred to as polymerization initiator (D)).

The colored curable resin composition of the present invention preferably further contains a solvent (hereinafter, sometimes referred to as solvent (E)).

The colored curable resin composition of the present invention may contain a leveling agent (hereinafter, sometimes referred to as leveling agent (F)).

Herein, compounds exemplified as components may be used singly or in combinations of a plurality thereof unless otherwise noted.

### Colorant (A)

The colorant (A) contains a compound represented by formula (I) or (II) (also referred to as (A1)) as a phthalocyanine compound. The compound is preferably a compound having an absorption maximum wavelength in a near-infrared region (a wavelength of 700 to 2500 nm, preferably 700 to 1500 nm, and more preferably 700 to 1300 nm). The compound represented by formula (I) is as follows.

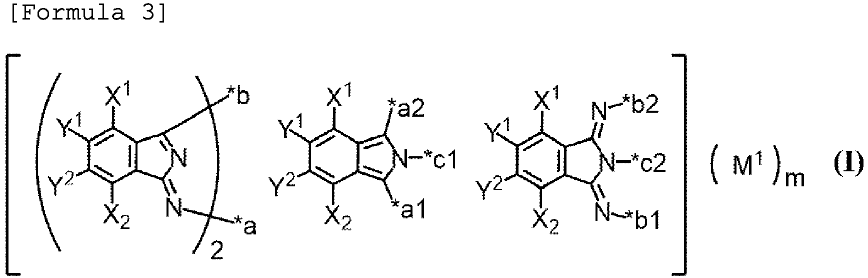

[In formula (1), X¹ and X² each independently represent a hydrogen atom, SR¹, or NR²R³.

Y¹ and Y² each independently represent a hydrogen atom, OR¹, or SR¹.

R¹ represents an aryl group having 6 to 20 carbon atoms or a heteroaryl group having 3 to 20 carbon atoms, and a hydrogen atom contained in the aryl group and the heteroaryl group is optionally replaced with a halogen atom or an alkoxy group having 1 to 20 carbon atoms.

R² and R³ each independently represent a hydrogen atom or an alkyl group having 1 to 10 carbon atoms. A methylene group contained in the alkyl group is optionally replaced with an oxygen atom. R² and R³ are optionally bonded to each other to form a nitrogen atom-containing ring.

A plurality of X¹, X², Y¹, Y², R¹, R², or R³, when present in one molecule, are optionally the same or different from each other.

M¹ represents a hydrogen atom, a monovalent metal atom, a divalent metal atom, a trivalent substituted metal atom, a tetravalent substituted metal atom, or an oxidized metal atom.

When M¹ is the hydrogen atom or the monovalent metal atom, m is 2; and when M¹ is the divalent metal atom, the trivalent substituted metal atom, the tetravalent substituted metal atom, or the oxidized metal atom, m is 1.

All of *a, *a1, *a2, *b, *b1, *b2, *c1, and *c2 represent a bond. One of two *a is bonded to *a1, and the other is bonded to *a2. One of two *b is bonded to *b1, and the other is bonded to *b2. *c1 and *c2 are bonded to M¹.]

The aryl group represented by R¹ may be, for example, a monocyclic or polycyclic (for example, bicyclic or tricyclic) aryl group, and specific examples thereof include a phenyl group, an o-tolyl group, a m-tolyl group, a p-tolyl group, a 2-ethylphenyl group, a 3-ethylphenyl group, a 4-ethylphenyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 4-vinylphenyl group, an o-isopropylphenyl group, a m-isopropylphenyl group, a p-isopropylphenyl group, an o-tert-buthylphenyl group, a m-tert-buthylphenyl group, a p-tert-buthylphenyl group, a 3,5-di(tert-butyl)phenyl group, a 3,5-di(tert-butyl)-4-methylphenyl group, a 4-buthylphenyl group, a 4-pentylphenyl group, a 2,6-bis(1-methylethyl)phenyl group, a 2,4,6-tris(1-methylethyl)phenyl group, a 4-cyclohexylphenyl group, a 2,4,6-trimethylphenyl group, a 4-octylphenyl group, a 4-(1,1,3,3-tetrametylbutyl)phenyl group, a 1-naphthyl group, 2-naphthyl group, a 6-methyl-2-naphthyl group, a 5,6,7,8-tetrahydro-1-naphthyl group, a 5,6,7,8-tetrahydro-2-naphthyl group, a fluorenyl group, a phenanthryl group, an anthryl group, 2-dodecylphenyl group, 3-dodecylphenyl group, 4-dodecylphenyl group, a phenanthryl group, a fluorenyl group, and a biphenyl group. The aryl group preferably has 6 to 18 carbon atoms, more preferably 6 to 15 carbon atoms, and still more preferably 6 to 12 carbon atoms.

The heteroaryl group represented by R¹ may be, for example, a monocyclic or polycyclic (for example, bicyclic or tricyclic) heteroaryl group, and specific examples thereof include a furanyl group, a benzofuranyl group, a pyridyl group, a pyrimidinyl group, a pyrazinyl group, a pyridazinyl group, a thienyl group, a benzothienyl group, an oxazolyl group, a benzoxazolyl group, a thiazolyl group, a benzothiazolyl group, an indolyl group, a carbazolyl group, an acridinyl group, an imidazolyl group, a benzoimidazolyl group, a quinolyl group, and an isoquinolyl group. The heteroaryl group preferably has 3 to 18 carbon atoms, more preferably 3 to 12 carbon atoms, and still more preferably 3 to 9 carbon atoms.

In the heteroaryl group, the number of elements constituting a ring is preferably 5 to 10.

The halogen atom which is optionally replaced with the hydrogen atom contained in the aryl group and the heteroaryl group is preferably a chlorine atom, a bromine atom, a fluorine atom, or an iodine atom.

Examples of the alkoxy group which is optionally replaced with the hydrogen atom contained in the aryl group and the heteroaryl group include a methoxy group, an ethoxy group, an n-propoxy group, an isopropoxy group, an n-butoxy group, an isobutoxy group, an s-butoxy group, a t-butoxy group, an n-pentyloxy group, an isopentyloxy group, a neopentyloxy group, an n-hexyloxy group, a cyclohexyloxy group, an n-heptyloxy group, an n-octyloxy group, a 2-ethylhexyloxy group, a t-octyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, and a nonadecyloxy group.

The alkoxy group preferably has 1 to 18 carbon atoms, more preferably 1 to 15 carbon atoms, still more preferably 1 to 10 carbon atoms, and yet still more preferably 1 to 8 carbon atoms.

Examples of the alkyl group represented by R² and R³ include straight-chain alkyl groups such as a methyl group, an ethyl group, a propyl group, a butyl group, a pentyl group, a hexyl group, a heptyl group, an octyl group, a nonyl group, and a decyl group; and branched-chain alkyl groups such as an isopropyl group, an isobutyl group, a sec-butyl group, a tert-butyl group, a 2-ethylbutyl group, 3,3-dimethylbutyl group, a 1,1,3,3-tetrametylbutyl group, a 1-methylbutyl group, a 1-ethylpropyl group, a 3-methylbutyl group, a neopentyl group, a 1,1-dimethylpropyl group, a 2-methylpentyl group, a 3-ethylpentyl group, a 1,3-dimethylbutyl group, a 2-propylpentyl group, a 1-ethyl-1,2-dimethylpropyl group, a 1-methylpentyl group, a 4-methylpentyl group, a 4-methylhexyl group, a 5-methylhexyl group, a 2-ethylhexyl group, a 1-methylhexyl group, a 1-ethylpentyl group, a 1-propylbutyl group, a 3-ethylheptyl group, a 2,2-dimethylheptyl group, a 1-methylheptyl group, a 1-ethylhexyl group, a 1-propylpentyl group, a 1-methyloctyl group, a 1-ethylheptyl group, a 1-propylhexyl group, a 1-butylpentyl group, a 1-methylnonyl group, a 1-ethyloctyl group, a 1-propylheptyl group, and a 1-butylhexyl group. The alkyl group preferably has 1 to 8 carbon atoms, more preferably 1 to 6 carbon atoms, and still more preferably 1 to 5 carbon atoms.

The group in which the methylene group of the alkyl group represented by R² and R³ is replaced with the oxygen atom is a group in which the methylene group constituting the alkyl group is replaced with the oxygen atom. The group in which the methylene group of the alkyl group is replaced with the oxygen atom is preferably a group having 1 to 10 carbon atoms, and more preferably a group having 1 to 6 carbon atoms (The methylene group before replaced with the oxygen atom is not included in the number of carbon atoms. For example, the ethoxy group has 2 carbon atoms). The alkyl group represented by R² and R³ is preferably a straight-chain alkyl group. Examples of the group include groups represented by the following formulas. In the following formulas, * represents a bond.

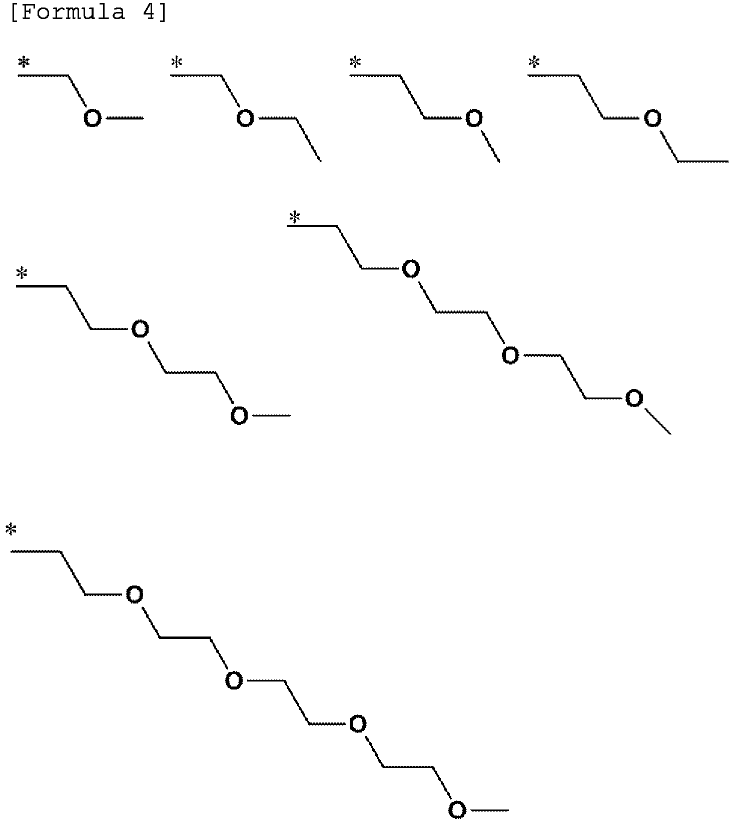

Examples of the nitrogen atom-containing ring formed by bonding R² and R³ to each other include nitrogen-containing non-aromatic 4- to 7-membered rings such as a pyrrolidine ring, a morpholine ring, a piperidine ring, and a piperazine ring.

SR¹ represented by X¹ and X² is preferably an arylsulfanyl group having 6 to 20 carbon atoms or a heteroarylsulfanyl group having 3 to 20 carbon atoms.

Examples of the arylsulfanyl group include a group in which a monocyclic or polycyclic (for example, bicyclic or tricyclic) aryl group is bonded to a sulfur atom. Specific examples thereof include a phenylsulfanyl group, a naphthylsulfanyl group, an anthrylsulfanyl group, a pyrenylsulfanyl group, an o-tolylsulfanyl group, a p-tolylsulfanyl group, a 2,6-dimethylphenylsulfanyl group, and a 2,4,6-trimethylphenylsulfanyl group. In particular, preferred is a group in which a monocyclic or bicyclic aryl group is bonded to a sulfur atom. Particularly preferred are a phenylsulfanyl group and a naphthylsulfanyl group. The arylsulfanyl group preferably has 6 to 18 carbon atoms, more preferably 6 to 15 carbon atoms, and still more preferably 6 to 12 carbon atoms.

Examples of the heteroarylsulfanyl group include a group in which a monocyclic or polycyclic (for example, bicyclic or tricyclic) heteroaryl group is bonded to a sulfur atom. Specific examples thereof include a group in which a pyridyl group, a pyrimidine group, an indolyl group, a quinoline group, a benzimidazole group, a furanyl group, a thienyl group, a benzofuran group, or a 1,3,4-thiadiazole group or the like is bonded to a sulfur atom. In particular, preferred is a group in which a monocyclic or bicyclic heteroaryl group is bonded to a sulfur atom. The heteroarylsulfanyl group preferably has 3 to 18 carbon atoms, more preferably 3 to 12 carbon atoms, and still more preferably 3 to 9 carbon atoms.

Examples of NR₂R₃ represented by X¹ and X² include a secondary or tertiary amino group. Specific examples thereof include an n-propylamino group, an isopropylamino group, an n-butylamino group, an n-pentylamino group, an n-hexylamino group, a cyclohexylamino group, an n-heptylamino group, an n-octylamino group, a 2-ethylhexylamino group, a dimethylamino group, a diethylamino group, a dipropylamino group, a dibutylamino group (di-n-butylamino group), an ethylbutylamino group, a di(2-ethylhexyl)amino group, a pyrrolidino group, a piperidino group, 4-methylpiperazino group, and a morpholino group. Preferred is a secondary or tertiary amino group replaced with a straight-chain alkyl group having 1 to 8 carbon atoms, a branched-chain alkyl group having 3 to 8 carbon atoms, or a cyclic alkyl group having 3 to 8 carbon atoms. Particularly preferred are an n-butylamino group, a 2-ethylhexylamino group, a dimethylamino group, a diethylamino group, and a dibutylamino group.

It is preferable that any one of R² and R³ a hydrogen atom, and the other be an alkyl group having 1 to 10 carbon atoms.

OR¹ represented by Y¹ and Y² is preferably an aryloxy group having 6 to 20 carbon atoms or a heteroaryloxy group having 3 to 20 carbon atoms.

Examples of the aryloxy group include a group in which a monocyclic or polycyclic (for example, bicyclic or tricyclic) aryl group is bonded to an oxygen atom. Specific examples thereof include a phenoxy group, an o-tolyloxy group, a p-tolyloxy group, a 2,4,6-trimethylphenoxy group, a naphthoxy group, an anthryloxy group, a phenanthrenyloxy group, a fluorenyloxy group, and a pyrenyloxy group. In particular, preferred is a group in which a monocyclic or bicyclic aryl group is bonded to an oxygen atom. Particularly preferred are a phenoxy group, an o-tolyloxy group, a 2,4,6-trimethylphenoxy group, a 1-naphthoxy group (1-naphthyloxy group), and a 2-naphthoxy group (2-naphthyloxy group). The aryloxy group preferably has 6 to 18 carbon atoms, more preferably 6 to 15 carbon atoms, and still more preferably 6 to 12 carbon atoms.

Examples of the heteroaryloxy group include a group in which a monocyclic or polycyclic (for example, bicyclic or tricyclic) heteroaryl group is bonded to an oxygen atom. Specific examples thereof include a group in which a pyridyl group, a pyrimidine group, an indolyl group, a quinoline group, a benzimidazole group, a furanyl group, a thienyl group, a benzofuran group, or a 1,3,4-thiadiazole group or the like is bonded to an oxygen atom. In particular, preferred is a group in which a monocyclic or bicyclic heteroaryl group is bonded to an oxygen atom. The heteroaryloxy group preferably has 3 to 18 carbon atoms, more preferably 3 to 12 carbon atoms, and still more preferably 3 to 9 carbon atoms.

SR¹ represented by Y¹ and Y² is preferably an arylsulfanyl having 6 to 20 carbon atoms or a heteroarylsulfanyl having 3 to 20 carbon atoms, and examples thereof include the same as the arylsulfanyl group or heteroarylsulfanyl group described in X¹ and X².

M¹ represents a hydrogen atom, a monovalent metal atom, a divalent metal atom, a trivalent substituted metal atom, a tetravalent substituted metal atom, or an oxidized metal atom.

Examples of the monovalent metal atom include Na, K, and Li.

Examples of a metal atom contained in the divalent metal atom, the trivalent substituted metal atom, the tetravalent substituted metal atom, or the oxidized metal atom include metal atoms belonging to the groups 3 to 15 in the periodic table. Specific examples of the divalent metal atom include Cu, Zn, Fe, Co, Ni, Ru, Pb, Rh, Pd, Pt, Mn, Sn, and Pb.

Examples of the trivalent substituted metal atom include Al-F, Al-Cl, Al-Br, Al-I, Al-OH, Ga-F, Ga-Cl, Ga-Br, Ga-I, In-F, In-Cl, In-Br, In-I, Tl-F, Tl-Cl, Tl-Br, Tl-I, Al-C₆H₅, Al-C₆H₄(CH₃), In-C₆H₅, In-C₆H₄(CH₃), Mn(OH), Mn(OC₆H₅), Mn[OSi(CH₃)₃], Fe-Cl, and Ru-Cl.

Examples of the tetravalent substituted metal atom include CrCl₂, SiCl₂, SiBr₂, SiF₂, SiI₂, ZrCl₂, ZrI₂, GeCl₂, GeBr₂, GeF₂, GeI₂, SnCl₂, SnF₂, SnBr₂, TiF₂, TiCl₂, TiBr₂, Si(OH)₂, Ge(OH)₂, Zr(OH)₂, Mn(OH)₂, Sn(OH)₂, Ti(R¹⁰)₂, Cr(R¹⁰)₂, Si(R¹⁰)₂, Sn(R¹⁰)₂, and Ge(R¹⁰)₂ [in formula, R¹⁰ represents an alkyl group, a phenyl group, a naphthyl group, or a derivative thereof], Si(OR²⁰)₂, Sn(OR²⁰)₂, Ge(OR²⁰)₂, Ti(OR²⁰)₂, and Cr(OR²⁰)₂ [in formula, R²⁰ is an alkyl group, a phenyl group, a naphthyl group, a trialkylsilyl group, a dialkylalkoxysilyl group, or a derivative thereof], and Sn(SR³⁰)₂ and Ge(SR³⁰)₂ [in formula, R³⁰ represents an alkyl group, a phenyl group, a naphthyl group, or a derivative thereof].

Examples of the oxidized metal atom include VO, MnO, and TiO.

M¹ is more preferably Cu, Zn, Fe, Co, Ni, Pd, Mg, VO, and TiO, still more preferably Cu, Zn, Ni, and VO, and particularly preferably Cu and VO.

In formula (I), when M¹ is the hydrogen atom or the monovalent metal atom, m is 2; and when M¹ is the divalent metal atom, the trivalent substituted metal atom, the tetravalent substituted metal atom, or the oxidized metal atom, m is 1.

All of *a, *a1, *a2, *b, *b1, *b2, *c1, and *c2 represent a bond. One of two *a is bonded to *a1, and the other is bonded to *a2. One of two *b is bonded to *b1, and the other is bonded to *b2. *c1 and *c2 are bonded to M¹.

In such bonding, the compound represented by formula (I) represents compounds represented by formulas (I-1) to (1-4) to be described later.

In formula (I), X¹ and X² each independently represent a hydrogen atom, SR¹, or NR²R³, and a combination of X¹ and X² is preferably a combination of a hydrogen atom and SR¹ or a combination of SR¹ and NR²R³.

It is preferable that Y¹ and Y² be each independently a hydrogen atom or SR¹.

R¹ is preferably an aryl group having 6 to 20 carbon atoms, more preferably an aryl group having 6 to 18 carbon atoms, and still more preferably a phenyl group, an o-tolyl group, a m-tolyl group, a p-tolyl group, or a 2,4,6-trimethylphenyl group. It is preferable that R² and R³ be each independently a hydrogen atom or an alkyl group having 1 to 10 carbon atoms. It is more preferable that R² and R³ be each independently a hydrogen atom or an alkyl having 1 to 8 carbon atoms. It is still more preferable that R² and R³ be each independently a hydrogen atom, a methyl group, an ethyl group, a propyl group, a butyl group, or a pentyl group.

It is preferable that m be 1, and M¹ be the divalent metal atom or the oxidized metal atom.

M¹ is preferably an oxidized metal atom belonging to the group 5 in the periodic table or a divalent metal atom belonging to the groups 9 to 12 in the periodic table, and more preferably VO, Ni, Pd, Co, Zn, or Cu.

In the present application, formula (I) may be abbreviated as formula (Ia). A compound represented by formula (Ia) is the same as the compound represented by formula (I).

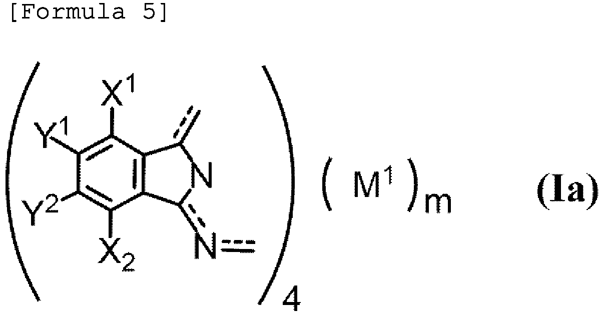

A compound represented by formula (II) is as follows. 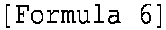 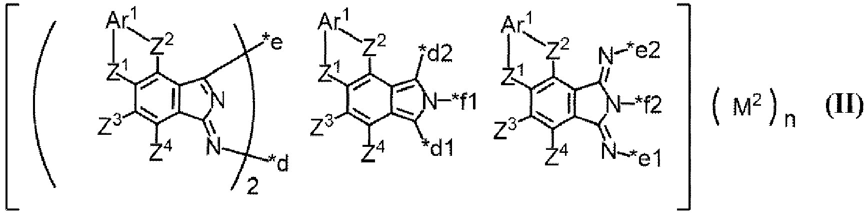 [In formula (II), Z¹ and Z² each independently represent an oxygen atom, a sulfur atom, or NR⁴.

R⁴ represents a hydrogen atom or an alkyl group having 1 to 10 carbon atoms, and a methylene group contained in the alkyl group is optionally replaced with an oxygen atom.

Ar¹ represents an arylene group having 6 to 20 carbon atoms or a heteroarylene having 3 to 20 carbon atoms, and a hydrogen atom contained in the arylene group and the heteroarylene group is optionally replaced with a halogen atom or an alkoxy group having 1 to 20 carbon atoms.

Z³ and Z⁴ each independently represent a hydrogen atom, N(R⁶)₂, OR⁵, or SR⁵.

R⁵ represents an alkyl group having 1 to 20 carbon atoms, an aryl group having 6 to 20 carbon atoms, or a heteroaryl group having 3 to 20 carbon atoms. A hydrogen atom contained in the alkyl group is optionally replaced with a halogen atom, and a methylene group contained in the alkyl group is optionally replaced with an oxygen atom. A hydrogen atom contained in the aryl group and the heteroaryl group is optionally replaced with a halogen atom or an alkoxy group having 1 to 20 carbon atoms.

R⁶ represents a hydrogen atom or an alkyl group having 1 to 10 carbon atoms, wherein a hydrogen atom contained in the alkyl group is optionally replaced with an aryl group having 6 to 10 carbon atoms, and wherein a methylene group contained in the alkyl group is optionally replaced with an oxygen atom.

A plurality of Z¹, Z², Z³, Z⁴, Ar¹, R⁴, R⁵, or R⁶, when present in one molecule, are optionally the same or different from each other.

M² represents a hydrogen atom, a monovalent metal atom, a divalent metal atom, a trivalent substituted metal atom, a tetravalent substituted metal atom, or an oxidized metal atom.

When M² is the hydrogen atom or the monovalent metal atom, n is 2, and when M² is the divalent metal atom, the trivalent substituted metal atom, the tetravalent substituted metal atom, or the oxidized metal atom, n is 1.

All of *d, *d1, *d2, *e, *e1, *e2, *f1, and *f2 represent a bond. One of two *d is bonded to *d1, and the other is bonded to *d2. One of two *e is bonded to *e1, and the other is bonded to *e2. *f1 and *f2 are bonded to M².]

Examples of the alkyl group represented by R⁴ include the same as the alkyl group described in R² and R³. A hydrogen atom contained in the alkyl group represented by R⁴ is optionally replaced with an aryl group having 6 to 20 carbon atoms.

Examples of the alkyl group represented by R⁵ include an undecyl group, a dodecyl group, a tridecyl group, a tetradecyl group, a pentadecyl group, a hexadecyl group, a heptadecyl group, an octadecyl group, a nonadecyl group, and an icosyl group, in addition to the alkyl group represented by R⁴. The alkyl group preferably has 1 to 18 carbon atoms, more preferably 1 to 15 carbon atoms, still more preferably 1 to 12 carbon atoms, yet still more preferably 1 to 10 carbon atoms, and particularly preferably 2 to 8 carbon atoms.

The group in which the methylene group of the alkyl group represented by R⁴, R⁵, and R⁶ is replaced with the oxygen atom is a group in which the methylene group constituting the alkyl group is replaced with the oxygen atom. The group in which the methylene group of the alkyl group is replaced with the oxygen atom is preferably a group having 1 to 10 carbon atoms, and more preferably a group having 1 to 6 carbon atoms (A methylene group before replaced with an oxygen atom is not included in the number of carbon atoms. For example, the ethoxy group has 2 carbon atoms). The alkyl group represented by R⁴, R⁵, and R⁶ is preferably a straight-chain alkyl group. Examples of the group include groups represented by the following formulas. In the following formulas, * represents a bond.

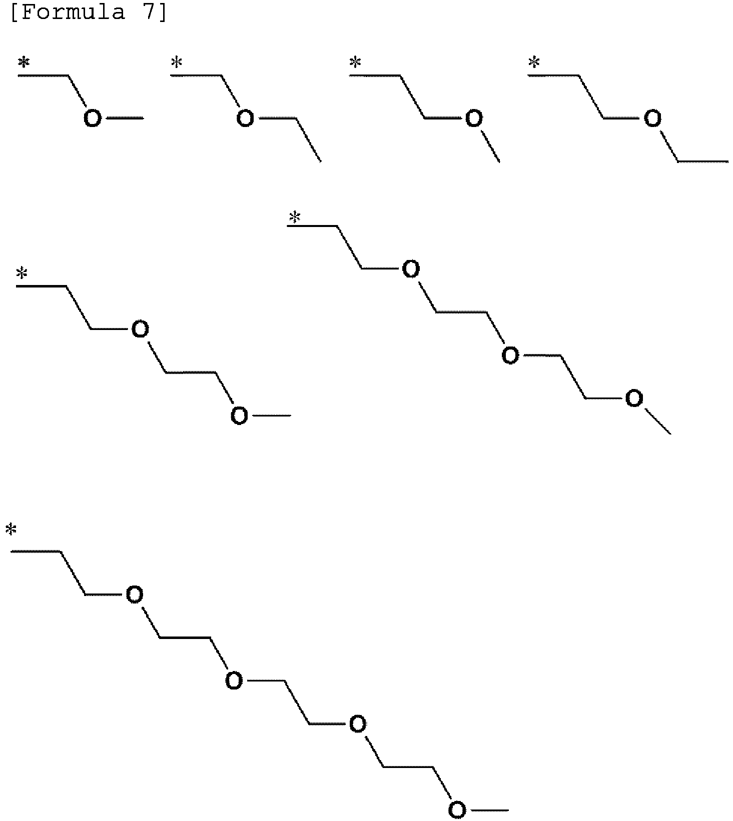

Examples of the aryl group having 6 to 20 carbon atoms or the heteroaryl group having 3 to 20 carbon atoms as represented by R⁵ include the same as the aryl group or heteroaryl group described in R¹.

Examples of the alkyl group having 1 to 10 carbon atoms represented by R⁶ include the same as the alkyl group described in R² to R⁴. A hydrogen atom contained in the alkyl group is optionally replaced with an aryl group having 6 to 10 carbon atoms, and examples of the aryl group include the same as the aryl group described in R¹ and R⁵.

Examples of the arylene group having 6 to 20 carbon atoms or the heteroarylene group having 3 to 20 carbon atoms as represented by Ar¹ include a divalent group in which the hydrogen atom contained in the aryl group or heteroaryl group described in R¹ is removed and replaced with a single bond. The arylene group or the heteroarylene group preferably has 3 to 18 carbon atoms, more preferably 3 to 12 carbon atoms, and still more preferably 3 to 9 carbon atoms.

Among these, preferred is an arylene group, and more preferred are a phenyldiyl group, a diphenyldiyl group, a naphthalenediyl group, an anthracenediyl group, a fluorenediyl group, and a biphenylene group (for example, biphenyl-2,2'-diyl group) and the like.

The halogen atom which is optionally replaced with the hydrogen atom contained in the alkyl group represented by R⁵, and the halogen atom which is optionally replaced with the hydrogen atom contained in the arylene group and heteroarylene group represented by Ar¹ are preferably a chlorine atom, a bromine atom, a fluorine atom, and an iodine atom.

Examples of the alkoxy group having 1 to 20 carbon atoms which is contained in the aryl group and heteroaryl group represented by R⁵, and is optionally replaced with the hydrogen atom, and the alkoxy group having 1 to 20 carbon atoms which is contained in the arylene group and heteroarylene group represented by Ar¹, and is optionally replaced with the hydrogen atom include the same as the alkoxy group which is optionally replaced with the hydrogen atom contained in the aryl group and heteroaryl group described in R¹.

Examples of NR⁴(-N(R⁴)-) represented by Z¹ and Z² include -N(CH₃)-, -N(CH₂CH₃)-, -N(CH₂CH₂CH₃)-, - N(CH₂(CH₃)CH₃)-, -N(CH₂CH₂CH₂CH₃)-, -N(CH₂CH₂(CH₃)CH₃)-, - N(CH₂CH₂CH₂CH₂CH₃)-, -N(CH₂CH₂CH₂CH₂CH₂CH₃)-, - N(CH₂CH₂CH₂CH₂CH₂CH₂CH₃)-, -N(CH₂CH₂CH₂CH₂CH₂CH₂CH₂CH₃)-, - N(CH₂CH₂CH₂CH₂CH₂CH₂CH₂CH₂CH₃)-, and - N(CH₂CH₂CH₂CH₂CH₂CH₂CH₂CH₂CH₂CH₃)-.

Examples of N(R⁶)₂ represented by Z³ and Z⁴ include an amino group, a methylamino group, an ethylamino group, a 2-ethylhexylamino group, an N,N-dimethylamino group, an N-ethyl-N-methylamino group, an N,N-diethylamino group, an N-propyl-N-methylamino group, an N,N-dipropylamino group, an N-isopropyl-N-methylamino group, an N,N-diisopropylamino group, an N,N-diisobutylamino group, an N,N-di(sec-butyl)amino group, an N-(tert-butyl)-N-methylamino group, an N,N-di(tert-butyl)amino group, an N-butyl-N-methylamino group, and an N,N-dibutylamino group.

OR⁵ represented by Z³ and Z⁴ is preferably an alkoxy group having 1 to 20 carbon atoms, an aryloxy group having 6 to 20 carbon atoms, or a heteroaryloxy group having 3 to 20 carbon atoms. Examples of the alkoxy group having 1 to 20 carbon atoms, the aryloxy group having 6 to 20 carbon atoms, or the heteroaryloxy group having 3-20 carbon atoms include the same as the alkoxy group having 1 to 20 carbon atoms which is contained in the aryl group and heteroaryl group described in R⁵, and is optionally replaced with the hydrogen atom, and the same as the aryloxy group or heteroaryloxy group described in Y¹ and Y².

SR⁵ represented by Z³ and Z⁴ is preferably an alkylsulfanyl having 1 to 20 carbon atoms, an arylsulfanyl group having 6 to 20 carbon atoms, or a heteroarylsulfanyl group having 3 to 20 carbon atoms.

Examples of the arylsulfanyl group having 6 to 20 carbon atoms or the heteroarylsulfanyl group having 3 to 20 carbon atoms include the same as the arylsulfanyl group or heteroarylsulfanyl group represented by X¹ and X².

Examples of the alkylsulfanyl having 1 to 20 carbon atoms include an alkoxy group in which an oxygen atom is replaced with a sulfur atom in the alkoxy group having 1 to 20 carbon atoms which is contained in the aryl group and heteroaryl group represented by R⁵ and is optionally replaced with the hydrogen atom.

M² represents a hydrogen atom, a monovalent metal atom, a divalent metal atom, a trivalent substituted metal atom, a tetravalent substituted metal atom, or an oxidized metal atom.

Examples of the monovalent metal atom include Na, K, and Li.

Examples of a metal atom contained in the divalent metal atom, the trivalent substituted metal atom, the tetravalent substituted metal atom, or the oxidized metal atom include metal atoms belonging to the groups 3 to 15 in the periodic table.

Specific examples of the divalent metal atom include Cu, Zn, Fe, Co, Ni, Ru, Pb, Rh, Pd, Pt, Mn, Sn, and Pb.

Examples of the trivalent substituted metal atom include Al-F, Al-Cl, Al-Br, Al-I, Al-OH, Ga-F, Ga-Cl, Ga-Br, Ga-I, In-F, In-Cl, In-Br, In-I, Tl-F, Tl-Cl, Tl-Br, Tl-I, Al-C₆H₅, Al-C₆H₄(CH₃), In-C₆H₅, In-C₆H₄(CH₃), Mn(OH), Mn(OC₆H₅), Mn[OSi(CH₃)₃], Fe-Cl, and Ru-Cl.

Examples of the tetravalent substituted metal atom include CrCl₂, SiCl₂, SiBr₂, SiF₂, SiI₂, ZrCl₂, ZrI₂, GeCl₂, GeBr₂, GeF₂, GeI₂, SnCl₂, SnF₂, SnBr₂, TiF₂, TiCl₂, TiBr₂, Si(OH)₂, Ge(OH)₂, Zr(OH)₂, Mn(OH)₂, Sn(OH)₂, Ti(R¹⁰)₂, Cr(R¹⁰)₂, Si(R¹⁰)₂, Sn(R¹⁰)₂, and Ge(R¹⁰)₂ [in formula, R¹⁰ represents an alkyl group, a phenyl group, a naphthyl group, or a derivative thereof], Si (OR²⁰)₂, Sn(OR²⁰)₂, Ge(OR²⁰)₂, Ti(OR²⁰)₂, and Cr(OR²⁰)₂ [in formula, R²⁰ is an alkyl group, a phenyl group, a naphthyl group, a trialkylsilyl group, a dialkylalkoxysilyl group, or a derivative thereof], and Sn(SR³⁰)₂ and Ge(SR³⁰)₂ [in formula, R³⁰ represents an alkyl group, a phenyl group, a naphthyl group, or a derivative thereof].

Examples of the oxidized metal atom include VO, MnO, and TiO.

M² is more preferably Cu, Zn, Fe, Co, Ni, Pd, Mg, VO, and TiO, still more preferably Cu, Zn, Ni, and VO, and particularly preferably Cu and VO.

When M² is the hydrogen atom or the monovalent metal atom, n is 2, and when M² is the divalent metal atom, the trivalent substituted metal atom, the tetravalent substituted metal atom, or the oxidized metal atom, n is 1.

All of *d, *d1, *d2, *e, *e1, *e2, *f1, and *f2 represent a bond. One of two *d is bonded to *d1, and the other is bonded to *d2. One of two *e is bonded to *e1, and the other is bonded to *e2. *f1 and *f2 are bonded to M².

In such bonding, the compound represented by formula (II) represents compounds represented by formulas (II-1) to (II-4) to be described later.

In formula (II), Z¹ and Z² each independently represent an oxygen atom, a sulfur atom, or NR⁴.

A combination of Z¹ and Z² is preferably a combination of an oxygen atom and an oxygen atom or a combination of a sulfur atom and NR⁴. R⁴ is preferably a hydrogen atom or an alkyl group having 1 to 10 carbon atoms, more preferably a hydrogen atom or an alkyl having 1 to 8 carbon atoms, and still more preferably a hydrogen atom, a methyl group, an ethyl group, a propyl group, a butyl group, a pentyl group, a hexyl group, a 2-ethylhexyl group, or a 1-phenylmethyl group.

Ar¹ is preferably an arylene group having 6 to 20 carbon atoms, more preferably an arylene group having 6 to 18 carbon atoms, and still more preferably a biphenyl-2,2'-diyl group or a phenyl-1,2-diyl group.

Z³ and Z⁴ are preferably each independently SR⁵, OR⁵, or N(R⁶)₂.

A combination of Z³ and Z⁴ is more preferably a combination of OR⁵ and N(R⁶)₂, a combination of OR⁵ and OR⁵, or a combination of OR⁵ and SR⁵.

R⁵ is preferably an alkyl group having 1 to 20 carbon atoms or an aryl group having 6 to 20 carbon atoms, more preferably an aryl group having 6 to 20 carbon atoms, and still more preferably a 1-naphthyl group, a 2-naphthyl group, an o-tolyl group, a m-tolyl group, a p-tolyl group, a 2,4,6-trimethylphenyl group, or a (1,1-dimethyl-3,3-dimethylbutyl)phenyl group. R⁶ is preferably a hydrogen atom or an alkyl group having 1 to 8 carbon atoms. M² is preferably an oxidized metal atom belonging to the group 5 in the periodic table, or a divalent metal atom belonging to the groups 9 to 12 in the periodic table, and more preferably VO, Ni, Pd, Co, Zn, or Cu.

In the present application, formula (II) may be abbreviated as formula (IIa). A compound represented by formula (IIa) is the same as the compound represented by formula (II).

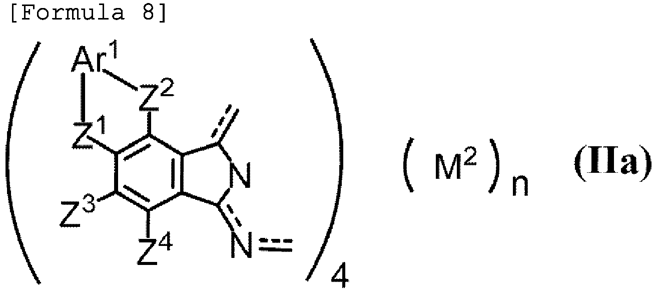

The colorant (A) preferably contains one or more of compounds represented by formulas (I-1) to (1-4) or one or more of compounds represented by formulas (II-1) to (II-4). 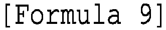 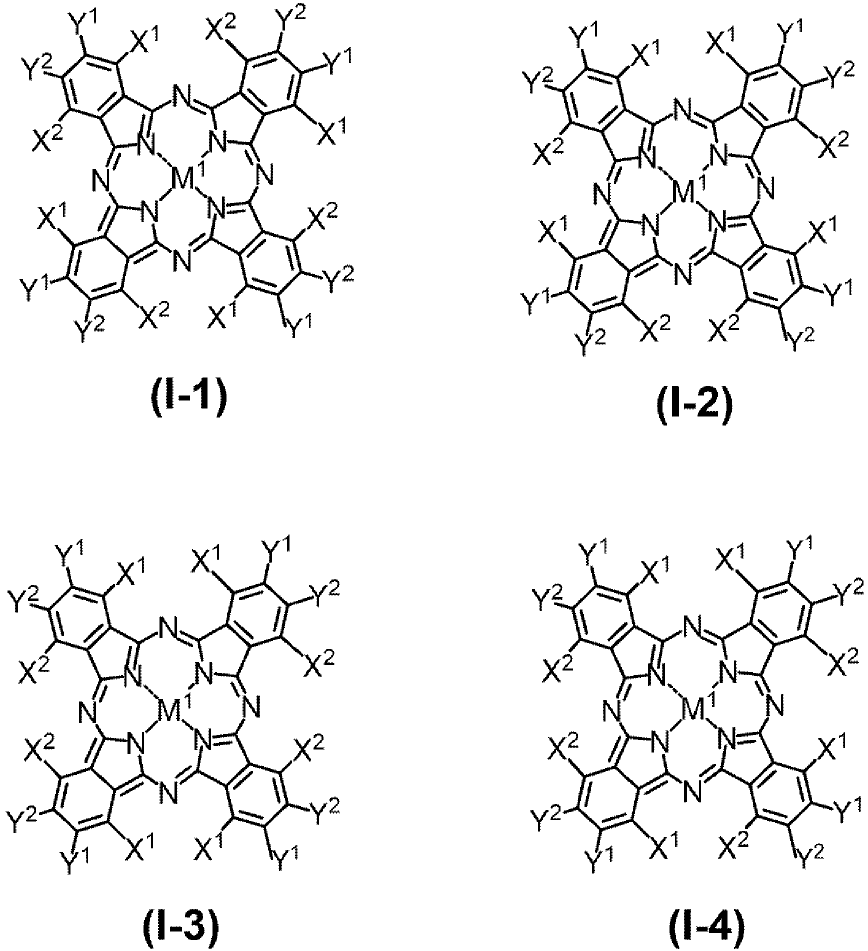 (in formula, X¹, X², Y¹, Y², and M¹ have the same meanings as above.) 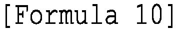 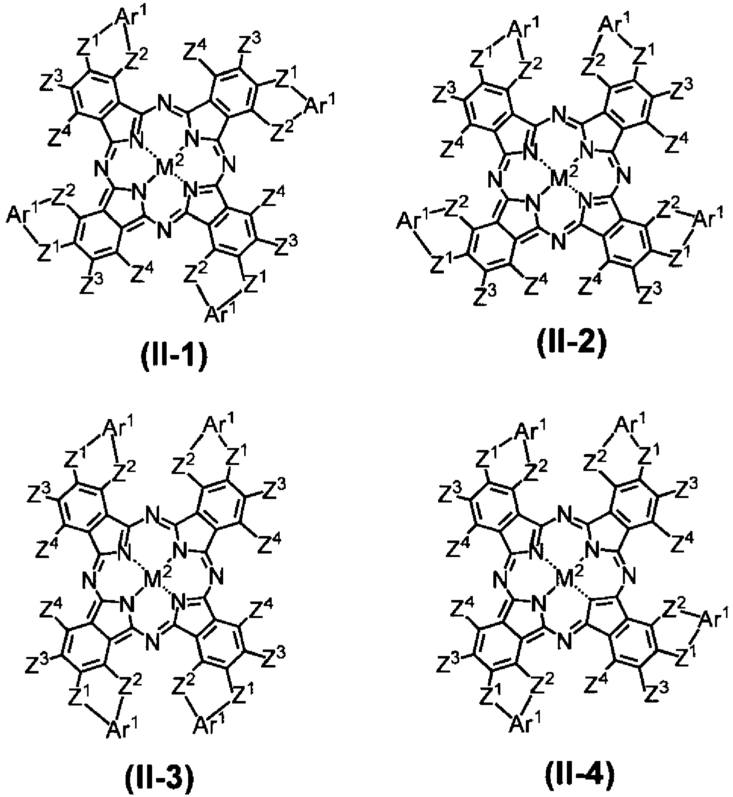 (in formula, Z¹, Z², Ar¹, Z³, Z⁴, and M² have the same meanings as above.)

The content rate of the compound (colorant (A1)) represented by formula (I) or (II) in the whole amount of the colorant (A) is preferably 20 to 100% by mass, more preferably 30 to 100% by mass, and still more preferably 40 to 100% by mass.

The content rate of the colorant (A1) is preferably 2 to 60% by mass, more preferably 4 to 55% by mass, and still more preferably 6 to 50% by mass, in the whole amount of the solid content of the colored curable resin composition.

Herein, the term "whole amount of solid content" means the total amount of components obtained by excluding the solvent from the colored curable resin composition of the present invention. The whole amount of the solid content and the content of each of the components with respect thereto can be measured by known analysis means such as liquid chromatography or gas chromatography.

The colorant (A) preferably further contains a different colorant from the colorant (A1) (hereinafter, also referred to as colorant (A2)).

The colorant (A2) may be any of a dye and a pigment.

Examples of the dye include a compound which is not a pigment but classified into a compound having a hue in the Color Index (published by The Society of Dyers and Colourists), and a known dye as described in Dying note (Shikisensha Co., Ltd.). Particularly preferred is a xanthene dye.

The xanthene dye is a dye containing a compound having a xanthene skeleton in its molecule. Specific examples of the xanthene dye include C.I. Acid Red 51 (hereinafter, the description of C.I. Acid Red is omitted and only the number is described, and the same is true on other dyes), 52, 87, 92, 94, 289, or 388; C.I. Acid Violet 9, 30, or 102; C.I. Basic Red 1 (Rhodamine 6G), 2, 3, 4, 8, 10, or 11; C.I. Basic Violet 10 (Rhodamine B) or 11; C.I. Solvent Red 218; C.I. Mordant Red 27; C.I. Reactive Red 36 (Rose Bengal B); Sulforhodamine G; a xanthene dye described in Japanese Patent Laid-Open No. 2010-32999; and a xanthene dye described in Japanese Patent No. 4492760. The xanthene dye is preferably dissolved in an organic solvent.

The xanthene dye which can be used is any commercially available xanthene dye (for example, "Chugai Aminol Fast Pink R-H/C" manufactured by Chugai Kasei Co., Ltd., or "Rhodamin 6G" manufactured by Taoka Chemical Co., Ltd.). The xanthene dye can also be synthesized with a commercially available xanthene dye as a starting material, with reference to Japanese Patent Laid-Open No. 2010-32999.

As the other dye, an azo dye, a cyanine dye, a triphenylmethane dye, a thiazole dye, an oxazine dye, a phthalocyanine dye, a quinophtharone dye, an anthraquinone dye, a naphthoquinone dye, a quinonimine dye, a methine dye, an azomethine dye, a squarylium dye, an acridine dye, a styryl dye, a coumarin dye, a quinoline dye, and a nitro dye and the like may be used, and for each of these dyes, known dyes are used.

Specific examples of such a dye include
C. I. Solvent dyes such as:
   C. I. Solvent Yellows 4 (hereinafter, the term "C. I. Solvent Yellow" is omitted and only the number is described), 14, 15, 23, 24, 38, 62, 63, 68, 82, 94, 98, 99, 117, 162, 163, 167, and 189;
   C. I. Solvent Reds 45, 49, 111, 125, 130, 143, 145, 146, 150, 151, 155, 168, 169, 172, 175, 181, 207, 222, 227, 230, 245, 247;
   C. I. Solvent Oranges 2, 7, 11, 15, 26, 56, 77, and 86;
   C. I. Solvent Violets 11, 13, 14, 26, 31, 36, 37, 38, 45, 47, 48, 51, 59, and 60;
   C. I. Solvent Blues 4, 5, 14, 18, 35, 36, 37, 45, 58, 59, 59:1, 63, 67, 68, 69, 70, 78, 79, 83, 90, 94, 97, 98, 100, 101, 102, 104, 105, 111, 112, 122, 128, 132, 136, 139;
   C. I. Solvent Greens 1, 3, 4, 5, 7, 28, 29, 32, 33, 34, and 35,
C. I. Acid dyes such as:
   C. I. Acid Yellows 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, 251;
   C. I. Acid Reds 1, 4, 8, 14, 17, 18, 26, 27, 29, 31, 33, 34, 35, 37, 40, 42, 44, 50, 57, 66, 73, 76, 80, 88, 91, 95, 97, 98, 103, 106, 111, 114, 129, 133, 134, 138, 143, 145, 150, 151, 155, 158, 160, 172, 176, 182, 183, 195, 198, 206, 211, 215, 216, 217, 227, 228, 249, 252, 257, 258, 260, 261, 266, 268, 270, 274, 277, 280, 281, 308, 312, 315, 316, 339, 341, 345, 346, 349, 382, 383, 394, 401, 412, 417, 418, 422, 426;
   C. I. Acid Oranges 6, 7, 8, 10, 12, 26, 50, 51, 52, 56, 62, 63, 64, 74, 75, 94, 95, 107, 108, 169, and 173;
   C. I. Acid Violets 6B, 7, 15, 16, 17, 19, 21, 23, 24, 25, 34, 38, 49, 72;
   C.I. acid blue 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 242, 243, 256, 259, 267, 269, 278, 280, 285, 290, 296, 315, 324:1, 335, 340;
   C. I. Acid Greens 1, 3, 5, 6, 7, 8, 9, 11, 13, 14, 15, 16, 22, 25, 27, 28, 41, 50, 50:1, 58, 63, 65, 80, 104, 105, 106, and 109,
C. I. Direct dyes such as:
   C. I. Direct Yellows 2, 33, 34, 35, 38, 39, 43, 47, 50, 54, 58, 68, 69, 70, 71, 86, 93, 94, 95, 98, 102, 108, 109, 129, 136, 138, 141;
   C. I. Direct Reds 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, 250;
   C. I. Direct Oranges 26, 34, 39, 41, 46, 50, 52, 56, 57, 61, 64, 65, 68, 70, 96, 97, 106, and 107;
   C. I. Direct Violets 47, 52, 54, 59, 60, 65, 66, 79, 80, 81, 82, 84, 89, 90, 93, 95, 96, 103, and 104;
   C. I. Direct Blues 1, 2, 3, 6, 8, 15, 22, 25, 28, 29, 40, 41, 42, 47, 52, 55, 57, 71, 76, 77, 78, 80, 81, 84, 85, 86, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 189, 190, 192, 193, 194, 195, 196, 198, 199, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275, 293;
   C. I. Direct Greens 25, 27, 31, 32, 34, 37, 63, 65, 66, 67, 68, 69, 72, 77, 79, and 82,
C. I. Disperse dyes such as:
   C. I. Disperse Yellows 51, 54, and 76;
   C. I. Disperse Violets 26 and 27;
   C. I. Disperse Blues 1, 14, 56, and 60,
C. I. Basic dyes such as:
   C. I. Basic Blues 1, 3, 5, 7, 9, 19, 21, 22, 24, 25, 26, 28, 29, 40, 41, 45, 47, 54, 58, 59, 60, 64, 65, 66, 67, 68, 81, 83, 88, and 89;
   C. I. Basic Violet 2;
   C. I. Basic Red 9;
   C. I. Basic Green 1;
C. I. Reactive dyes such as:
   C. I. Reactive Yellows 2, 76, and 116;
   C. I. Reactive Orange 16;
   C. I. Reactive Red 36;
C. I. Mordant dyes such as:
   C. I. Mordant Yellows 5, 8, 10, 16, 20, 26, 30, 31, 33, 42, 43, 45, 56, 61, 62, and 65;
   C. I. Mordant Reds 1, 2, 3, 4, 9, 11, 12, 14, 17, 18, 19, 22, 23, 24, 25, 26, 29, 30, 32, 33, 36, 37, 38, 39, 41, 42, 43, 45, 46, 48, 52, 53, 56, 62, 63, 71, 74, 76, 78, 85, 86, 88, 90, 94, 95;
   C. I. Mordant Oranges 3, 4, 5, 8, 12, 13, 14, 20, 21, 23, 24, 28, 29, 32, 34, 35, 36, 37, 42, 43, 47, and 48;
   C. I. Mordant Violets 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53, 58;
   C. I. Mordant Blues 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83, 84;
   C. I. Mordant Greens 1, 3, 4, 5, 10, 13, 15, 19, 21, 23, 26, 29, 31, 33, 34, 35, 41, 43, and 53; and
C. I. Vat dyes such as:
   C. I. Vat Green 1.

Examples of the pigment include a pigment which is classified into a pigment in the Color Index (published by The Society of Dyers and Colourists), and the following pigments can be exemplified:
green pigments: C.I. Pigment Greens 7, 36, and 58 and the like;
yellow pigments: C.I. Pigment Yellows 1, 3, 12, 13, 14, 15, 16, 17, 20, 24, 31, 53, 83, 86, 93, 94, 109, 110, 117, 125, 128, 129, 137, 138, 139, 147, 148, 150, 153, 154, 166, 173, 185, 194, and 214 and the like;
orange pigments: C.I. Pigment Oranges 13, 31, 36, 38, 40, 42, 43, 51, 55, 59, 61, 64, 65, 71, and 73 and the like;
red pigments: C.I. Pigment Reds 9, 97, 105, 122, 123, 144, 149, 166, 168, 176, 177, 180, 192, 209, 215, 216, 224, 242, 254, 255, 264, and 265 and the like;
blue pigments: C.I. Pigment Blues 15, 15:3, 15:4, 15:6, and 60 and the like;
violet pigments: C.I. Pigment Violets 1, 19, 23, 29, 32, 36, and 38 and the like; and

One pigment or a plurality of pigments may be used for each of the colors of these pigments, and the pigments of the colors may be combined.

These pigments may be subjected to a rosin treatment, a surface treatment using a pigment derivative or the like having an introduced acidic group or basic group, a pigment surface graft treatment with a polymeric compound or the like, a particle micronization treatment with a sulfuric acid micronization method or the like, a washing treatment with an organic solvent, water or the like for removing impurities, a removing treatment with an ionic exchange method or the like of ionic impurities or the like, if required. The pigment preferably has a substantially uniform particle diameter. To the pigment, a pigment dispersant is added, followed by performing a dispersion treatment, whereby a pigment dispersion in which the pigment is uniformly dispersed in a pigment dispersant solution can be produced. The pigments may be each independently subjected to a dispersion treatment, or the plurality of pigments may be mixed, followed by performing a dispersion treatment.

Examples of the pigment dispersant include the same as the above.

When the pigment dispersant is used, the amount thereof used is preferably 10 parts by mass or more and 200 parts by mass or less, more preferably 15 parts by mass or more and 180 parts by mass or less, and still more preferably 20 parts by mass or more and 160 parts by mass or less, based on 100 parts by mass of the pigment. When the amount of the pigment dispersant used falls within the range, and two or more pigments are used, a pigment dispersion in the form of a more uniform dispersion tends to be obtained.

When the colorant (A) contains the colorant (A2), the content rate of the colorant (A2) is preferably 1 to 80% by mass, more preferably 1 to 70% by mass, and still more preferably 1 to 60% by mass, in the whole amount of the colorant (A).

The content rate of the colorant (A) in the colored curable resin composition is commonly 1% by mass or more and 70% by mass or less, preferably 2% by mass or more and 65% by mass or less, more preferably 5% by mass or more and 60% by mass or less, and particularly preferably 7% by mass or more and 55% by mass or less, relative to the whole amount of the solid content. When the content rate of the compound falls within the range, desired spectroscopy and color density are more likely to be obtained.

### <Resin (B)>

The resin (B) is not particularly limited, and is preferably an alkali soluble resin. Examples of the resin (B) include the following resins [K1] to [K6].
Resin [K1]; a copolymer having a structural unit derived from at least one (a) selected from the group consisting of an unsaturated carboxylic acid and an unsaturated carboxylic anhydride (hereinafter, sometimes referred to as "(a)") and a structural unit derived from a monomer (b) having a cyclic ether structure having 2 to 4 carbon atoms and an ethylenically unsaturated bond (hereinafter, sometimes referred to as "(b)");
Resin [K2]; a copolymer having a structural unit derived from (a), a structural unit derived from (b), and a monomer (c) copolymerizable with (a) (provided that (c) is different from (a) and (b)) (hereinafter, sometimes referred to as "(c)");
Resin [K3]; a copolymer having a structural unit derived from (a) and a structural unit derived from (c);
Resin [K4]; a copolymer having a structural unit produced by adding (b) to a structural unit derived from (a) and a structural unit derived from (c);
Resin [K5]; a copolymer having a structural unit produced by adding (a) to a structural unit derived from (b) and a structural unit derived from (c); and
Resin [K6]; a copolymer having a structural unit produced by adding (a) to a structural unit derived from (b) and further adding a carboxylic anhydride thereto and a structural unit derived from (c).

Specific examples of (a) include unsaturated monocarboxylic acids such as acrylic acid, methacrylic acid, crotonic acid, and o-, m- or p-vinylbenzoic acid;
unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
carboxy group-containing bicyclo unsaturated compounds such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;
unsaturated dicarboxylic anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride;
unsaturated mono[(meth)acryloyloxyalkyl]esters of a polyvalent carboxylic acid having a valence of 2 or more such as succinic acid mono[2-(meth)acryloyloxyethyl], and phthalic acid mono[2-(meth)acryloyloxyethyl]; and
unsaturated acrylates containing a hydroxy group and a carboxy group in the same molecule such as **α-**(hydroxymethyl)acrylic acid.

Among these, from the viewpoint of copolymerization reactivity and solubility of a resin to be produced to an alkaline aqueous solution, acrylic acid, methacrylic acid, maleic anhydride and the like are preferable.

(b) means a polymerizable compound having, for example, a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether having 2 to 4 carbon atoms and a (meth)acryloyloxy group.

As used herein, "(meth)acrylic acid" represents at least one selected from the group consisting of acrylic acid and methacrylic acid. The terms "(meth)acryloyl", "(meth)acrylate" and the like also have similar meanings.

Examples of (b) include a monomer having an oxiranyl group and an ethylenically unsaturated bond (b1) (hereinafter, sometimes referred to as "(b1)"), a monomer having an oxetanyl group and an ethylenically unsaturated bond (b2) (hereinafter, sometimes referred to as "(b2)"), and a monomer having a tetrahydrofuryl group and an ethylenically unsaturated bond (b3) (hereinafter, sometimes referred to as "(b3)").

Examples of (b1) include a monomer having a structure where a linear or branched aliphatic unsaturated hydrocarbon is epoxidized (b1-1) (hereinafter, sometimes referred to as "(b1-1)") and a monomer having a structure where an alicyclic unsaturated hydrocarbon is epoxidized (b1-2) (hereinafter, sometimes referred to as "b1-2").

Examples of (b1-1) include glycidyl(meth)acrylate, **β**-methylglycidyl(meth)acrylate, **β-**ethylglycidyl(meth)acrylate, glycidyl vinyl ether, o-vinylbenzyl glycidyl ether, m-vinylbenzyl glycidyl ether, p-vinylbenzyl glycidyl ether, **α**-methyl-o-vinylbenzyl glycidyl ether, **α**-methyl-m-vinylbenzyl glycidyl ether, **α**-methyl-p-vinylbenzyl glycidyl ether, 2,3-bis(glycidyloxymethyl)styrene, 2,4-bis(glycidyloxymethyl)styrene, 2,5-bis(glycidyloxymethyl)styrene, 2,6-bis(glycidyloxymethyl)styrene, 2,3,4-tris(glycidyloxymethyl)styrene, 2,3,5-tris(glycidyloxymethyl)styrene, 2,3,6-tris(glycidyloxymethyl)styrene, 3,4,5-tris(glycidyloxymethyl)styrene, and 2,4,6-tris(glycidyloxymethyl)styrene.

Examples of (b1-2) include vinylcyclohexene monoxide, 1,2-epoxy-4-vinylcyclohexane (for example, Celloxide 2000; manufactured by Daicel Corporation), 3,4-epoxycyclohexylmethyl(meth)acrylate (for example, Cyclomer A400; manufactured by Daicel Corporation), 3,4-epoxycyclohexylmethyl(meth)acrylate (for example, Cyclomer M100; manufactured by Daicel Corporation), 3,4-epoxytricyclo[5.2.1.0²⁻⁶]decyl(meth)acrylate, and 3,4-epoxytricyclo[5.2.1.0²⁻⁶]decyloxyethyl(meth)acrylate.

(b2) is more preferably a monomer having an oxetanyl group and a (meth)acryloyloxy group. Examples of (b2) include 3-methyl-3-methacryloyloxy methyl oxetane, 3-methyl-3-acryloyloxy methyl oxetane, 3-ethyl-3-methacryloyloxy methyl oxetane, 3-ethyl-3-acryloyloxy methyl oxetane, 3-methyl-3-methacryloyloxy ethyl oxetane, 3-methyl-3-acryloyloxy ethyl oxetane, 3-ethyl-3-methacryloyloxy ethyl oxetane, and 3-ethyl-3-acryloyloxy ethyl oxetane.

(b3) is more preferably a monomer having a tetrahydrofuryl group and a (meth)acryloyloxy group. Specific examples of (b3) include tetrahydrofurfuryl acrylate (for example, Viscoat V#150, manufactured by Osaka Organic Chemical Industry Ltd.) and tetrahydrofurfuryl methacrylate.

(b) is preferably (b1) since reliabilities such as heat resistance and chemical resistance of an optical filter to be produced can be further improved. Furthermore, (b1-2) is more preferable since the storage stability of the colored curable resin composition is excellent.

Examples of (c) include (meth)acrylic esters such as
methyl(meth)acrylate, ethyl(meth)acrylate, n-butyl(meth)acrylate, sec-butyl(meth)acrylate, tert-butyl(meth)acrylate, 2-ethylhexyl(meth)acrylate, dodecyl(meth)acrylate, lauryl(meth)acrylate, stearyl(meth)acrylate, cyclopentyl(meth)acrylate, cyclohexyl(meth)acrylate, 2-methylcyclohexyl(meth)acrylate, tricyclo[5.2.1.0^{2,6}]decan-8-yl(meth)acrylate (referred to as "dicyclopentanyl(meth)acrylate" (common name) in the art or sometimes referred to as "tricyclodecyl(meth)acrylate"), tricyclo [5.2.1.0^{2,6}]decene-8-yl (meth) acrylate (which is referred to as "dicyclopentenyl(meth)acrylate" (common name) in the art), dicyclopentanyloxyethyl(meth)acrylate, isobornyl(meth)acrylate, adamantyl(meth)acrylate, allyl(meth)acrylate, propargyl(meth)acrylate, phenyl(meth)acrylate, naphthyl(meth)acrylate, and benzyl(meth)acrylate;
hydroxy group-containing (meth)acrylic esters such as 2-hydroxyethyl(meth)acrylate and 2-hydroxypropyl(meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide;
styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance, styrene, vinyltoluene, N-phenylmaleimide, N-cyclohexylmaleimide, N-benzylmaleimide, bicyclo[2.2.1]hept-2-ene and the like are preferable.

In the resin [K1], the ratio of the structural unit derived from each of (a) and (b) in the total structural units constituting the resin [K1] is preferably the following:
the structural unit derived from (a); 2 to 60 mol%; and
the structural unit derived from (b); 40 to 98 mol%,
and more preferably the following:
   the structural unit derived from (a); 10 to 50 mol%; and
   the structural unit derived from (b); 50 to 90 mol%.

When the ratio of the structural unit of the resin [K1] falls within the above-mentioned range, there is a tendency that the storage stability of the colored curable resin composition, that the developability thereof during the formation of a colored pattern, and that the solvent resistance of an optical filter to be produced are excellent.

The resin [K1] can be produced with reference to the method described in for example, a document "Experimental Method for Polymer Synthesis" (edited by Takayuki Otsu, published by Kagaku Dojin Publishing Co., Ltd., First Edition, First Printed on Mar. 1, 1972) and cited documents described in the above-mentioned document.

Specific examples thereof include the following method: predetermined amounts of (a) and (b), a polymerization initiator, and a solvent and the like are placed in a reaction vessel; for example, a deoxidization atmosphere is formed by substituting oxygen with nitrogen; and these are heated or kept warm during stirring. The polymerization initiator, the solvent and the like which are used here are not particularly limited, and those commonly used in the art can be used. Examples of the polymerization initiator include azo compounds (2,2'-azobisisobutyronitrile, 2,2'-azobis(2,4-dimethylvaleronitrile) and the like) and organic peroxides (benzoyl peroxide and the like). The solvent may be a solvent capable of dissolving each monomer, and examples of the solvent (E) for the colored curable resin composition of the present invention include solvents to be described later.

A solution after a reaction, of the resultant copolymer may be used as it is; a concentrated or diluted solution of the copolymer may be used; or a solid (powder) taken out from the copolymer by a method such as reprecipitation may be used. In particular, the solution after the reaction can be used as it is for preparing the colored curable resin composition of the present invention by using the solvent contained in the colored curable resin composition of the present invention as the solvent during the polymerization, whereby the producing process of the colored curable resin composition of the present invention can be simplified.

In the resin [K2], the ratio of the structural unit derived from each of (a) to (c) in the total structural units constituting the resin [K2] is preferably the following:
the structural unit derived from (a); 2 to 45 mol%;
the structural unit derived from (b); 2 to 95 mol%; and
the structural unit derived from (c); 1 to 65 mol%,
and more preferably the following:
   the structural unit derived from (a); 5 to 40 mol%;
   the structural unit derived from (b); 5 to 80 mol%; and
   the structural unit derived from (c); 5 to 60 mol%.

When the ratio of the structural unit of the resin [K2] falls within the above-mentioned range, there is a tendency that the storage stability of the colored curable resin composition, the developability thereof during the formation of a colored pattern, and the solvent resistance, heat resistance, and mechanical strength of an optical filter to be produced are excellent.

The resin [K2] can be produced in the same manner as in the method described as the producing method of the resin [K1], for example.

In the resin [K3], the ratio of the structural unit derived from each of (a) and (c) in the total structural units constituting the resin [K3] is preferably the following:
the structural unit derived from (a); 2 to 60 mol%; and
the structural unit derived from (c); 40 to 98 mol%,
and more preferably the following:
   the structural unit derived from (a); 10 to 50 mol% and
   the structural unit derived from (c); 50 to 90 mol%.

The resin [K3] can be produced in the same manner as in the method described as the producing method of the resin [K1], for example.

The resin [K4] can be produced by producing a copolymer of (a) and (c) and then adding a cyclic ether having 2 to 4 carbon atoms contained in (b) to a carboxylic acid and/or a carboxylic anhydride contained in (a).

The copolymer of (a) and (c) is first produced in the same manner as in the method described as the producing method of the resin [K1]. In this case, the ratio of the structural unit derived from each of (a) and (c) is preferably the same ratio as that described in the resin [K3].

Next, a cyclic ether having 2 to 4 carbon atoms contained in (b) is reacted with a part of the carboxylic acid and/or the carboxylic anhydride derived from (a) in the copolymer.

Subsequent to the production of the copolymer of (a) and (c), a nitrogen atmosphere in a flask is replaced with air, and (b), a reaction catalyst for a carboxylic acid or a carboxylic anhydride and a cyclic ether (for example, tris(dimethylaminomethyl)phenol and the like), and a polymerization inhibitor (for example, hydroquinone and the like) are placed in a flask, followed by reacting, for example, at 60 to 130°C for 1 to 10 hours, whereby the resin [K4] can be produced.

The amount of (b) used is preferably 5 to 80 mol, and more preferably 10 to 75 mol, relative to 100 mol of (a). The amount of (b) used falls within the above-mentioned range, whereby there is a tendency that the storage stability of the colored curable resin composition, the developability thereof during the formation of a pattern, and the balance of the solvent resistance, heat resistance, mechanical strength, and sensitivity of the pattern obtained are good. Since the reactivity of the cyclic ether is high, and the unreacted (b) is less likely to remain, (b) used for the resin [K4] is preferably (b1), and more preferably (b1-1).

The amount of the reaction catalyst used is preferably 0.001 to 5 parts by mass relative to 100 parts by mass of the total amount of (a), (b), and (c). The amount of the polymerization inhibitor used is preferably 0.001 to 5 parts by mass relative to 100 parts by mass of the total amount of (a), (b), and (c).

Reaction conditions such as a feeding method, a reaction temperature, and time can be appropriately adjusted in consideration of a production equipment, an amount of heat generation due to polymerization, and the like. In consideration of the production equipment, the amount of heat generation due to polymerization, and the like, the feeding method and the reaction temperature can be appropriately adjusted like the polymerization conditions.

The resin [K5] is produced by producing a copolymer of (b) and (c) in the same manner as in the above-mentioned method for producing the resin [K1] as a first step. In the same manner as in the above, a solution after a reaction, of the resultant copolymer may be used as it is; a concentrated or diluted solution of the copolymer may be used; or a solid (powder) taken out from the copolymer by a method such as reprecipitation may be used.

The ratio of the structural unit derived from each of (b) and (c) relative to the total number of moles of the total structural units constituting the copolymer is preferably the following:
the structural unit derived from (b); 5 to 95 mol%; and
the structural unit derived from (c); 5 to 95 mol%, and more preferably the following:
   the structural unit derived from (b); 10 to 90 mol%; and
   the structural unit derived from (c); 10 to 90 mol%.

Furthermore, the resin [K5] can be produced by reacting a carboxylic acid or a carboxylic anhydride contained in (a) with the cyclic ether derived from (b) contained in the copolymer of (b) and (c) under the same conditions as those of the producing method of the resin [K4] .

The amount of (a) used which is reacted with the copolymer is preferably 5 to 80 mol relative to 100 mol of (b). Since the reactivity of the cyclic ether is high, and the unreacted (b) is less likely to remain, (b) used for the resin [K5] is preferably (b1), and more preferably (b1-1).

The resin [K6] is a resin produced by further reacting a carboxylic anhydride with the resin [K5]. A carboxylic anhydride is reacted with a hydroxy group generated by a reaction between a cyclic ether and a carboxylic acid or a carboxylic anhydride.

Examples of the carboxylic anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride. The amount of the carboxylic anhydride used is preferably 0.5 to 1 mol relative to 1 mol of the amount of (a) used.

Specific examples of the resin (B) include a resin [K1] such as a 3,4-epoxycyclohexylmethyl(meth)acrylate/(meth)acrylic acid copolymer or a 3,4-epoxytricyclo[5.2.1.0^{2.6}]decyl acrylate/(meth)acrylic acid copolymer; a resin [K2] such as a glycidyl(meth)acrylate/benzyl(meth)acrylate/(meth)acrylic acid copolymer, a glycidyl(meth)acrylate/styrene/(meth)acrylic acid copolymer, a 3,4-epoxytricyclo[5.2.1.0^{2.6}]decyl acrylate/(meth)acrylic acid/N-cyclohexylmaleimide copolymer, 3,4-epoxytricyclo[5.2.1.0^{2.6}]decyl acrylate/(meth)acrylic acid/N-cyclohexylmaleimide/2-hydroxyethyl(meth)acrylate copolymer, or a 3-methyl-3-(meth)acryloyloxymethyl oxetane/(meth)acrylic acid/styrene copolymer; a resin [K3] such as a benzyl(meth)acrylate/(meth)acrylic acid copolymer or a styrene/(meth)acrylic acid copolymer; a resin [K4] such as a resin produced by adding glycidyl(meth)acrylate to a benzyl(meth)acrylate/(meth)acrylic acid copolymer, a resin produced by adding glycidyl(meth)acrylate to a tricyclodecyl(meth)acrylate/styrene/(meth)acrylic acid copolymer, or a resin produced by adding glycidyl(meth)acrylate to a tricyclodecyl(meth)acrylate/benzyl(meth)acrylate/(meth)ac rylic acid copolymer; a resin [K5] such as a resin produced by reacting a tricyclodecyl(meth)acrylate/glycidyl(meth)acrylate copolymer with (meth)acrylic acid or a resin produced by reacting a tricyclodecyl(meth)acrylate/styrene/glycidyl(meth)acrylat e copolymer with (meth)acrylic acid; and a resin [K6] such as a resin produced by reacting a tricyclodecyl(meth)acrylate/glycidyl(meth)acrylate copolymer with (meth)acrylic acid to produce a resin and then reacting this resin with tetrahydrophthalic anhydride.

The resin (B) is preferably a copolymer having a structural unit derived from at least one selected from the group consisting of an unsaturated carboxylic acid and an unsaturated carboxylic anhydride and a structural unit having a cyclic ether structure having 2 to 4 carbon atoms and an ethylenically unsaturated bond (the resin [K1] or the resin [K2]), and more preferably the resin [K2].

The weight average molecular weight of the resin (B) in terms of polystyrene content is preferably 3,000 to 100,000, more preferably 5,000 to 50,000, and still more preferably 5,000 to 30,000. When the molecular weight falls within the above-mentioned range, there is a tendency that the hardness of the optical filter is improved, that the residual film ratio is increased, that the solubility of an unexposed area in a developing solution becomes good, and that the resolution of a colored pattern is improved.

The degree of dispersion [weight average molecular weight (Mw)/number average molecular weight (Mn)] of the resin (B) is preferably 1.1 to 6, and more preferably 1.2 to 4.

The acid value of the resin (B) is preferably 50 to 170 mg-KOH/g, more preferably 60 to 150 mg-KOH/g, and still more preferably 70 to 135 mg-KOH/g, in terms of solid content. The acid value as used herein is a value which is measured as an amount (mg) of potassium hydroxide required for neutralizing 1 g of the resin (B), and which can be determined by, for example, titration with an aqueous potassium hydroxide solution.

The content rate of the resin (B) is preferably 7 to 65% by mass, more preferably 13 to 60% by mass, and still more preferably 17 to 55% by mass, relative to the whole amount of the solid content. When the content rate of the resin (B) falls within the above-mentioned range, there is a tendency that the colored pattern can be formed, and that the resolution of the colored pattern and the residual film ratio are improved.

### <Polymerizable Compound (C)>

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and is preferably a (meth)acrylic acid ester compound.

Among these, the polymerizable compound (C) is preferably a polymerizable compound having three or more ethylenically unsaturated bonds. Examples of the polymerizable compound include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Among these, preferred are trimethylolpropane tri(meth)acrylate, dipentaerythritol penta(meth)acrylate, and dipentaerythritol hexa(meth)acrylate.

The weight average molecular weight of the polymerizable compound (C) is preferably 150 or more and 2,900 or less, and more preferably 250 or more and 1,500 or less.

The content rate of the polymerizable compound (C) is preferably 7 to 65% by mass, more preferably 13 to 60% by mass, and still more preferably 17 to 55% by mass, relative to the whole amount of the solid content. When the content rate of the polymerizable compound (C) falls within the above-mentioned range, there is a tendency that the residual film ratio during the formation of the colored pattern and the chemical resistance of the optical filter are improved.

### <Polymerization Initiator (D)>

The polymerization initiator (D) is not particularly limited, as long as the polymerization initiator (D) is a compound capable of generating active radicals, an acid or the like by the action of light or heat to initiate polymerization. Any known polymerization initiator can be used. Examples of the polymerization initiator capable of generating active radicals include an alkylphenone compound, a triazine compound, an acylphosphine oxide compound, an O-acyloxime compound, and a biimidazole compound.

The O-acyloxime compound is a compound having a partial structure represented by formula (d1). Hereinafter, * represents a point of attachment.

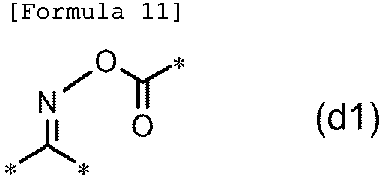

Examples of the O-acyloxime compound include N-benzoyloxy-1-(4-phenylsulfanylphenyl)butane-1-one-2-imine, N-benzoyloxy-1-(4-phenylsulfanylphenyl)octane-1-one-2-imine, N-benzoyloxy-1-(4-phenylsulfanylphenyl)-3-cyclopentylpropane-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, N-benzoyloxy-1-[9-ethyl-6-(2-methylbenzoyl)-9H-carbazole-3-yl]-3-cyclopentylpropane-1-one-2-imine, and N-acetyloxy-1-(4-phenylsulfanylphenyl)-3-cyclohexylpropane-1-one-2-imine. Commercially available products such as Irgacure OXE01, OXE02 (both manufactured by BASF Corporation), and N-1919 (manufactured by ADEKA Corporation) may be used. Among these, the O-acyloxime compound is preferably at least one selected from the group consisting of N-acetyloxy-1-(4-phenylsulfanylphenyl)-3-cyclohexylpropane-1-one-2-imine, N-benzoyloxy-1-(4-phenylsulfanylphenyl)butane-1-one-2-imine, N-benzoyloxy-1-(4-phenylsulfanylphenyl)octane-1-one-2-imine, and N-benzoyloxy-1-(4-phenylsulfanylphenyl)-3-cyclopentylpropane-1-one-2-imine, and more preferably N-acetyloxy-1-(4-phenylsulfanylphenyl)-3-cyclohexylpropane-1-one-2-imine, and N-benzoyloxy-1-(4-phenylsulfanylphenyl)octane-1-one-2-imine. There is a tendency that these O-acyloxime compounds provide an optical filter having a high brightness.

The alkylphenone compound is a compound having a partial structure represented by formula (d2) or a partial structure represented by formula (d3). In these partial structures, the benzene ring optionally has a substituent.

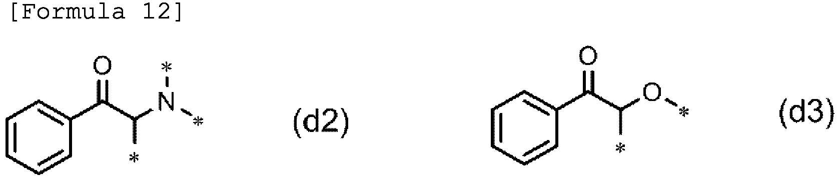

Examples of the compound having a partial structure represented by formula (d2) include 2-methyl-2-morpholino-1-(4-methylsulfanylphenyl)propane-1-one, 2-dimethylamino-1-(4-morpholinophenyl)-2-benzylbutane-1-one, and 2-(dimethylamino)-2-[(4-methylphenyl)methyl]-1-[4-(4-morpholinyl)phenyl]butane-1-one. Commercially available products such as Irgacures 369, 907, and 379 (all manufactured by BASF Corporation) may be used.

Examples of the compound having a partial structure represented by formula (d3) include 2-hydroxy-2-methyl-1-phenylpropane-1-one, 2-hydroxy-2-methyl-1-[4-(2-hydroxyethoxy)phenyl]propane-1-one, 1-hydroxycyclohexylphenylketone, an oligomer of 2-hydroxy-2-methyl-1-(4-isopropenylphenyl)propane-1-one, α,α-diethoxyacetophenone, and benzyl dimethyl ketal.

The alkylphenone compound is preferably a compound having a partial structure represented by formula (d2) from the viewpoint of sensitivity.

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine oxide compound include 2,4,6-trimethylbenzoyldiphenylphosphine oxide. Commercially available products such as Irgacure (registered trademark) 819 (manufactured by BASF Corporation) may be used.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. 6-75372 and Japanese Patent Laid-Open No. 6-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent No. 48-38403 and Japanese Patent Laid-Open No. 62-174204), and a biimidazole compound in which a phenyl group at the 4,4'5,5' position is substituted with a carboalkoxy group (for example, see Japanese Patent Laid-Open No. 7-10913).

Furthermore, examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenonne, 4-benzoyl-4'-methyldiphenyl sulfide, 3,3',4,4'-tetra(tert-butylperoxycarbonyl)benzophenone, and 2,4,6-trimethylbenzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound. These are preferably used in combination with a polymerization initiation aid (D1) (particularly, amines) to be described later.

Examples of a polymerization initiator which generates an acid include onium salts such as 4-hydroxyphenyldimethylsulfonium p-toluenesulfonate, 4-hydroxyphenyldimethylsulfoniumhexafluoroantimonate, 4-acetoxyphenyldimethylsulfonium p-toluenesulfonate, 4-acetoxyphenylmethylbenzylsulfoniumhexafluoroantimonate, triphenylsulfonium p-toluenesulfonate, triphenylsulfonium hexafluoroantimonate, diphenyliodonium p-toluenesulfonate, and diphenyliodoniumhexafluoroantimonate, nitrobenzyl tosylates, and benzoin tosylates.

The polymerization initiator (D) is preferably a polymerization initiator containing at least one selected from the group consisting of an alkylphenone compound, a triazine compound, an acylphosphine oxide compound, an O-acyloxime compound, and a biimidazole compound, and more preferably a polymerization initiator containing an O-acyloxime compound.

The content of the polymerization initiator (D) is preferably 0.1 to 30 parts by mass, and more preferably 1 to 20 parts by mass, relative to 100 parts by mass of the whole amount of the resin (B) and the polymerizable compound (C). When the content of the polymerization initiator (D) falls within the above-mentioned range, there is a tendency that the sensitivity is increased and that the time of exposure to light is shortened, resulting in the improvement in productivity of the optical filter.

### <Polymerization Initiation Aid (D1)>

The polymerization initiation aid (D1) is a compound to be used for accelerating polymerization of a polymerizable compound the polymerization of which has been started by the polymerization initiator or a sensitizer. When the polymerization initiation aid (D1) is contained, the polymerization initiation aid (D1) is commonly used in combination with the polymerization initiator (D).

Examples of the polymerization initiation aid (D1) include an amine compound, an alkoxyanthracene compound, a thioxanthone compound, and a carboxylic acid compound.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone. Among these, 4,4'-bis(diethylamino)benzophenone is preferable. Commercially available products such as EAB-F (manufactured by Hodogaya Chemical Co., Ltd.), may be used.

Examples of the alkoxy anthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

When the polymerization initiation aid (D1) is used, the content thereof is preferably 0.1 to 30 parts by mass, and more preferably 1 to 20 parts by mass, relative to 100 parts by mass of the whole amount of the resin (B) and the polymerizable compound (C). When the amount of the polymerization initiation aid (D1) falls within the above-mentioned range, there is a tendency that the colored pattern can be formed with higher sensitivity, resulting in the improvement in productivity of the optical filter.

<Solvent (E)>

The solvent (E) is not particularly limited, and any solvent which has been used conventionally in the art can be used. Examples of the solvent (E) include an ester solvent (a solvent which contains -COO- but does not contain -O- in its molecule), an ether solvent (a solvent which contains -O- but does not contain -COO- in its molecule), an ether ester solvent (a solvent which contains -COO- and -O- in its molecule), a ketone solvent (a solvent which contains -CO- but does not contain -COO-in its molecule), an alcohol solvent (a solvent which contains OH but does not contain -O-, -CO- nor -COO- in its molecule), an aromatic hydrocarbon solvent, an amide solvent, and dimethyl sulfoxide.

Examples of the ester solvent include methyl lactate, ethyl lactate, butyl lactate, methyl 2-hydroxy isobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-butyl methoxyacetate, 3-methyl-3-butyl methoxyacetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin.

Examples of the aromatic hydrocarbon solvent include benzene, toluene, xylene, and mesitylene.

Examples of the above amide solvent include N,N-dimethylformamide, N,N-dimethylacetamide, and N-methylpyrrolidone.

The solvent is preferably one or more selected from the group consisting of an ether solvent, an ether ester solvent, and an amide solvent, more preferably contains the ether solvent, the ether ester solvent, and the amide solvent, and still more preferably contains diethylene glycol methylethyl ether, propylene glycol monomethyl ether acetate, and N-methylpyrrolidone. The solvent provides high solubility of the colorant, whereby the foreign matter of the optical filter is less likely to occur.

The content rate of the solvent (E) is preferably 70 to 95% by mass, and more preferably 75 to 92% by mass, relative to the whole amount of the colored curable resin composition of the present invention. In other words, the solid content of the colored curable resin composition is preferably 5 to 30% by mass, and more preferably 8 to 25% by mass. When the content rate of the solvent (E) falls within the above-mentioned range, there is a tendency that the flatness during application becomes good and the color density of the optical filter formed becomes not insufficient, resulting in the achievement of good displaying properties.

The content rate of the ether solvent is preferably 1 to 55% by mass, more preferably 2 to 53% by mass, and still more preferably 3 to 50% by mass, relative to the whole amount of the solvent.

The content rate of the ether ester solvent is preferably 1 to 30% by mass, more preferably 2 to 25% by mass, and still more preferably 3 to 20% by mass, relative to the whole amount of the solvent.

The content rate of the amide solvent is preferably 1 to 50% by mass, more preferably 2 to 47% by mass, and still more preferably 3 to 45% by mass, relative to the whole amount of the solvent.

### <Leveling Agent (F)>

Examples of the leveling agent (F) include a silicone-based surfactant, a fluorine-based surfactant, and a silicone-based surfactant having a fluorine atom. These may have a polymerizable group at its side chain.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (trade name: manufactured by Dow Corning Toray Co., Ltd.); KP321, KP322, KP323, KP324, KP326, KP340, and KP341 (manufactured by Shin-Etsu Silicone Co., Ltd.); and TSF400, TSF401, TSF410, TSF4300, TSF4440, TSF4445, TSF4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by AGC Inc. (former Asahi Glass Co., Ltd.)); and E5844 (manufactured by Daikin Finechemical Laboratory).

Examples of the silicone-based surfactant having a fluorine atom include a surfactant having a siloxane bond and a fluorocarbon chain in its molecule. Specific examples thereof include Megafac (registered trademark) R08, Megafac BL20, Megafac F475, Megafac F477, and Megafac F443 (manufactured by DIC Corporation).

The content rate of the leveling agent (F) is preferably 0.001% by mass or more and 0.2% by mass or less, more preferably 0.002% by mass or more and 0.1% by mass or less, and still more preferably 0.01% by mass or more and 0.05% by mass or less, relative to the whole amount of the colored curable resin composition. This content rate does not include the content rate of the pigment dispersant. When the content rate of the leveling agent (F) falls within the above-mentioned range, the flatness of the optical filter can be improved.

### <Other Components>

If required, the colored curable resin composition of the present invention may contain an additive known in the art, such as a filler, other polymeric compound, an adhesion promoter, an antioxidant, a light stabilizer, or a chain transfer agent.

### <Method for Producing Colored Curable Resin Composition>

The colored curable resin composition of the present invention can be prepared by, for example, mixing a colorant (A), a resin (B), a polymerizable compound (C), and a polymerization initiator (D), and a solvent (E), a leveling agent (F), a polymerization initiation aid (D1), and other component used if required.

The colorant (A) may be prepared using the colored dispersion and the pigment dispersion. A desired colored curable resin composition can be prepared by mixing remaining components at predetermined concentrations in the colored dispersion or the pigment dispersion.

When the colored curable resin composition contains a dye, the dye may be dissolved in advance in a part of or whole of the solvent (E) to prepare a solution. The solution is preferably filtered by a filter having a pore size of about 0.01 to 1 µm.

The colored curable resin composition after mixing is preferably filtered by a filter having a pore size of about 0.01 to 10 µm.

### <Method for Producing Optical Filter>

Examples of the method for producing the colored pattern from the colored curable resin composition of the present invention include a photolithography method, an inkjet method, and a printing method. Among these methods, a photolithography method is preferable. The photolithography method is a method in which the colored curable resin composition is applied onto a substrate and then dried to form a coloring composition layer, and the coloring composition layer is then developed by exposing the coloring composition layer to light through a photomask. In the photolithography method, the photomask is not used during the exposure to light, and/or the coloring composition layer is not developed, whereby a colored coating film which is a hardened material of the coloring composition layer can be formed. The colored pattern and the colored coating film which have been formed thus are the optical filter of the present invention.

The film thickness of the optical filter to be prepared is not particularly limited, and can be appropriately adjusted depending on objects, applications and the like. For example, the film thickness of the optical filter is 0.1 to 30 µm, preferably 0.1 to 20 µm, and more preferably 0.5 to 6 µm.

Examples of the substrate to be used include glass substrates such as quartz glass, borosilicate glass, alumina silicate glass, and soda lime glass of which the surface is coated with silica; resin substrates such as polycarbonate, poly(methyl methacrylate), and polyethylene terephthalate; silicon; and substrates on which aluminum, silver, or a silver/copper/palladium alloy thin film or the like is formed. On these substrates, other optical filter layer, a resin layer, a transistor, a circuit and the like may be formed.

The formation of each color pixel using a photolithography method can be carried out using a known or conventional device or under known or conventional conditions. For example, the color pixel can be prepared in the following manner.

First, a colored curable resin composition is applied onto a substrate, and then dried by heat-drying (prebaking) and/or drying under reduced pressure to remove volatile components such as a solvent from the composition, thereby producing a smooth coloring composition layer.

Examples of the application method include a spin coat method, a slit coat method, and a slit-and-spin coat method.

The temperature to be employed when heat-drying is carried out is preferably 30 to 120°C, and more preferably 50 to 110°C. The time for the heating is preferably 10 seconds to 60 minutes, and more preferably 30 seconds to 30 minutes.

When drying under reduced pressure is carried out, the drying procedure is preferably carried out at a temperature range of 20 to 25°C under a pressure of 50 to 150 Pa.

The film thickness of the coloring composition layer is not particularly limited, and may be selected appropriately depending on the desired film thickness of the optical filter.

Next, the coloring composition layer is exposed to light through a photomask for forming a desired colored pattern. The pattern on the photomask is not particularly limited, and a pattern suitable for the intended application is used.

A light source to be used for the exposure to light is preferably a light source capable of generating light having a wavelength of 250 to 450 nm. For example, light having a wavelength of shorter than 350 nm may be cut with a filter capable of cutting light having this wavelength region, or light having a wavelength of around 436 nm, around 408 nm, or around 365 nm may be extracted selectively with a band-pass filter capable of extracting light having those wavelength region. Specific examples thereof include a mercury lamp, a light-emitting diode, a metal halide lamp, and a halogen lamp.

A light-exposing device such as a mask aligner and a stepper is preferably used because the device is capable of emitting a parallel light beam uniformly over the whole area of the exposed surface or accurately aligning the photomask to the substrate which has the coloring composition layer formed thereon.

A colored pattern is formed on the substrate by bringing the exposed coloring composition layer into contact with a developing solution to develop the coloring composition layer. By developing, an unexposed area in the coloring composition layer is dissolved in the developing solution and therefore removed. The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01 to 10% by mass, and more preferably 0.03 to 5% by mass. The developing solution may further contain a surfactant.

The developing method may be any of a paddle method, a dipping method, a spray method and the like. Furthermore, during the developing process, the substrate may be inclined at any angle.

After the developing process, the resultant product is preferably washed with water.

Furthermore, the resultant colored pattern is preferably subjected to post-baking. The temperature for the post-baking is preferably 150 to 250°C, and more preferably 160 to 250°C. The time for the post-baking is preferably 1 to 120 minutes, and more preferably 5 to 60 minutes.

According to the colored curable resin composition of the present invention, an optical filter in which foreign matter is less likely occur can be prepared. The optical filter is useful as a film used for a display device (for example, a liquid crystal display device, an organic EL device, or an electronic paper or the like) and a solid-state image sensor.

### Examples

Hereinafter, the present invention will be described in more detail with reference to Examples. However, of course, the present invention is not limited to the following Examples, and various design variations made in accordance with the purports described hereinbefore and hereinafter are also included in the technical scope of the present invention. Hereinafter, unless otherwise specified, "parts" means "parts by mass" and "%" means "% by mass".

### Synthetic Example 1

A proper amount of nitrogen was flown into a flask equipped with a reflux condenser, a dropping funnel, and a stirrer to purge the inside of the flask with a nitrogen atmosphere. Then, 340 parts of propylene glycol monomethylether acetate was added into the flask, and then heated to 80°C while stirring. Subsequently, there was added dropwise, to the flask over 5 hours, a mixed solution containing 57 parts of acrylic acid, 54 parts of a mixture of 3,4-epoxytricyclo[5.2.1.0^{2,6}]decan-8-ylacrylate and 225 parts of 3,4-epoxytricyclo[5.2.1.0^{2,6}]decan-9-ylacrylate (the content ratio was 1:1 by mole), 239 parts of benzyl methacrylate, and 73 parts of propylene glycol monomethyl ether acetate. On the other hand, there was added dropwise, to the solution over 6 hours, a solution prepared by dissolving 40 parts of a polymerization initiator, 2,2-azo bis(2,4-dimethylvaleronitrile), in 197 parts of propylene glycol monomethylether acetate. After the completion of the dropwise addition of the initiator solution, the solution was retained at 80°C for 3 hours, and then cooled to room temperature to obtain a copolymer (resin B-1) solution. The resin B-1 solution had a solid content of 37.0% and a viscosity of 127 mPas as measured with a Type-B viscometer (23°C). The formed copolymer had a weight average molecular weight Mw of 9.4 × 10³, a degree of dispersion of 1.89, and an acid value of 114 mg-KOH/g in terms of solid content. The resin B-1 has the following structural units.

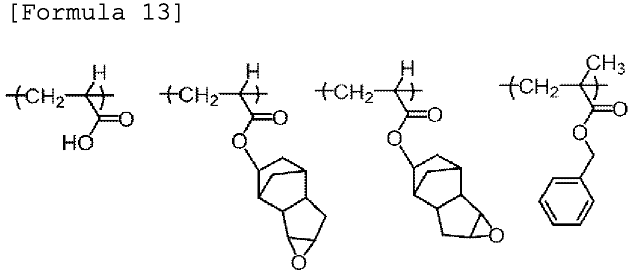

### Example 1

### [Preparation of Colored Curable Resin Composition 1]

A colored curable resin composition 1 was obtained by mixing the following components.
Colorant (A): Phthalocyanine compound Pc-02 (Compound 1) described in Material Example 1 of Japanese Patent Application Laid-Open No. 2014-19838: 4.50 parts
Resin (B): Resin (B-1) obtained in Synthesis Example 1: 23.6 parts (in terms of solids)
Polymerizable compound (C): (C-1) (Dipentaerythritol polyacrylate: trade name A9550, manufactured by Shin-Nakamura Chemical Co., Ltd.): 7.86 parts (in terms of solids)
(C-2) (Trimethylolpropane triacrylate: trade name A-TMPT, manufactured by Shin-Nakamura Chemical Co., Ltd.): 7.86 parts
Polymerization initiator (D): (D-1) N-acetyloxy-1-(4-phenylsulfanylphenyl)-3-cyclohexylpropane-1-one-2-imine: trade name TR-PBG327 (manufactured by CHANGZHOU TRONLY NEW ELECTRONIC MATERIALS Co., Ltd.): 1.18 parts
Solvent (E): (E-1) Propylene glycol monomethyl ether acetate: 52.4 parts
Solvent (E): (E-2) Diethylene glycol ethyl methyl ether: 111 parts
Solvent (E): (E-3) N-methylpyrrolidone: 91.6 parts
Leveling agent (F): Polyether modified silicone oil (Toray silicone SH8400; manufactured by Toray Dow Corning Co., Ltd.): 0.045 parts

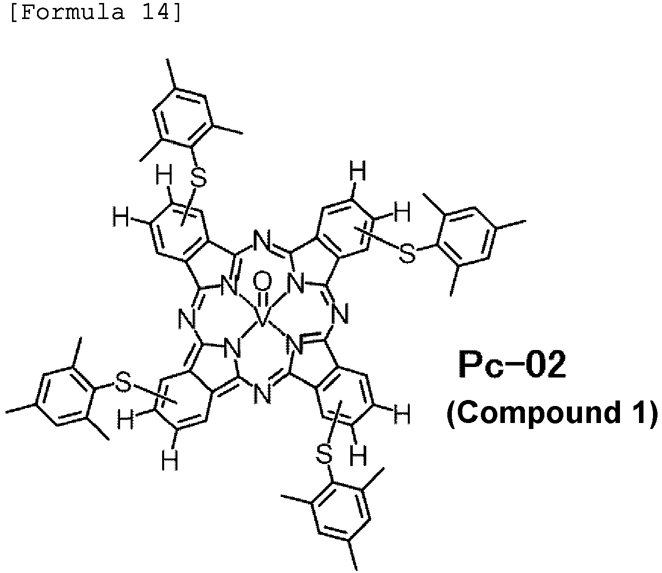

### Examples 2 to 10

### [Preparation of Colored Curable Resin Compositions 2 to 10]

Colored curable resin compositions 2 to 10 were obtained in the same manner as in Example 1 except that the colorant (A) of Example 1 was replaced with the following phthalocyanine compounds (Compounds 2 to 10).

### Example 2: Phthalocyanine compound (1-5) (Compound 2) described in Example 5 of WO2014/208514

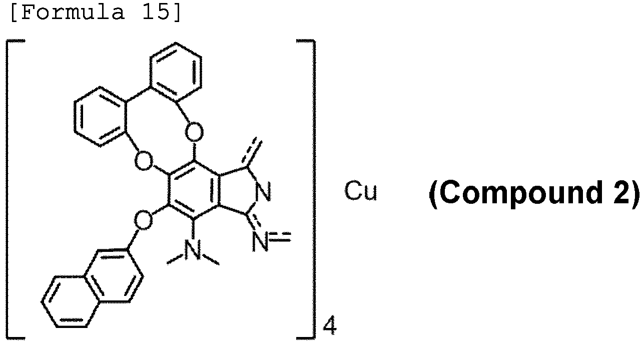

### Example 3: Phthalocyanine compound (1-3) (Compound 3) described in Example 3 of WO2014/208514

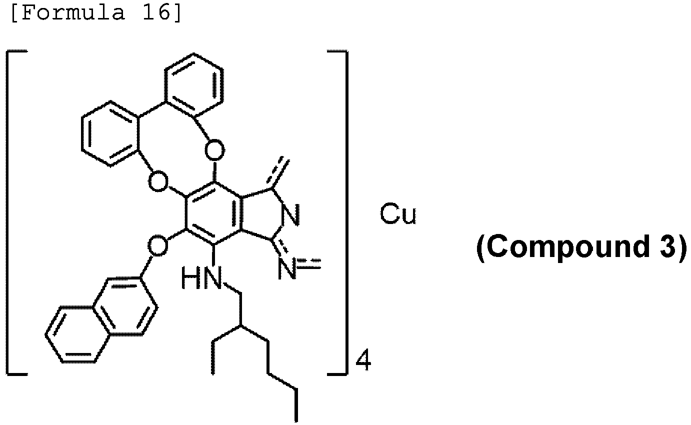

### Example 4: Phthalocyanine compound (1-8) (Compound 4) described in Example 8 of WO2014/208514

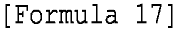

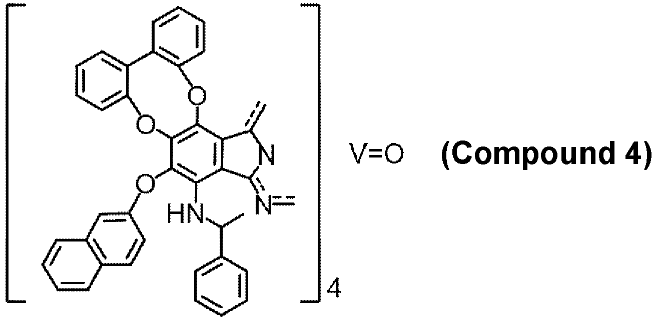

### Example 5: Phthalocyanine compound (1-2) (Compound 5) described in Example 2 of WO2014/208514

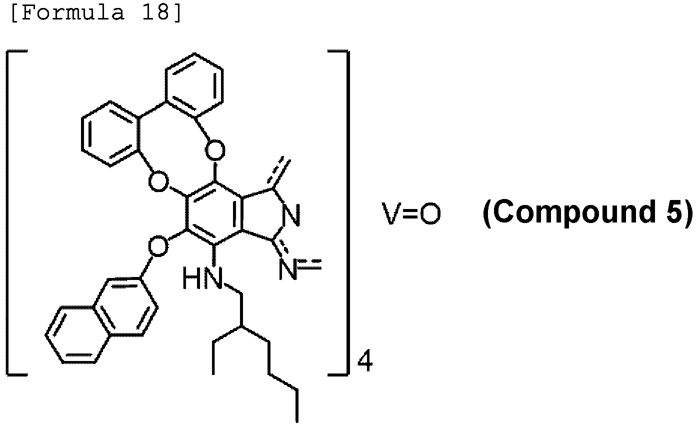

### Example 6: Phthalocyanine compound of Compound Example 93 (Compound 6) represented by Chemical Formula 11 described in Synthesis Example 8 of Japanese Patent Laid-Open No. 2013-108060

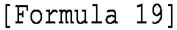

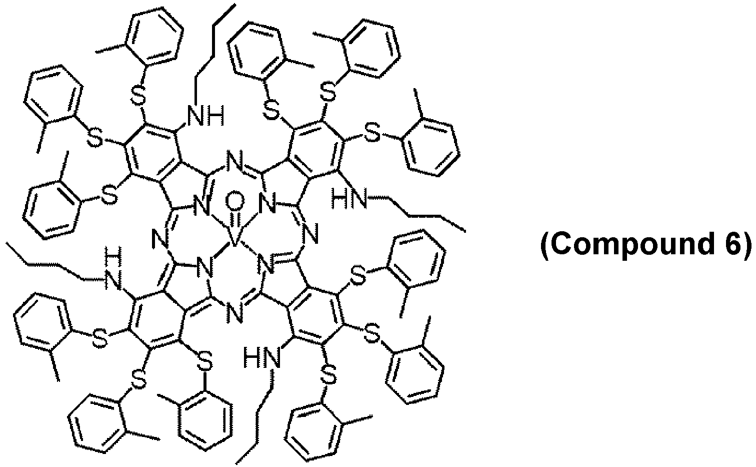

### Example 7: Phthalocyanine compound (1-6) (Compound 7) described in Example 6 of WO2014/115692

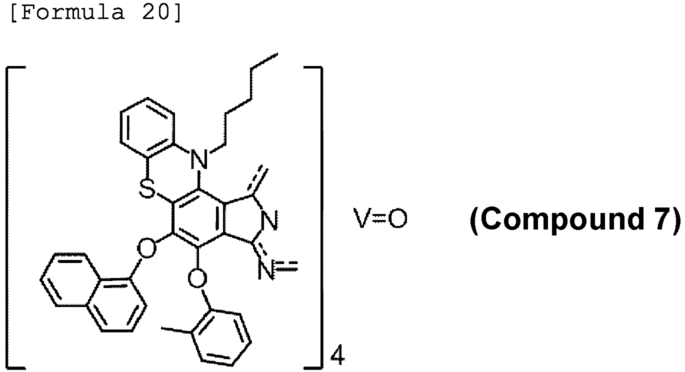

### Example 8: Phthalocyanine compound (1-2) (Compound 8) described in Example 2 of WO2014/115692

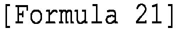

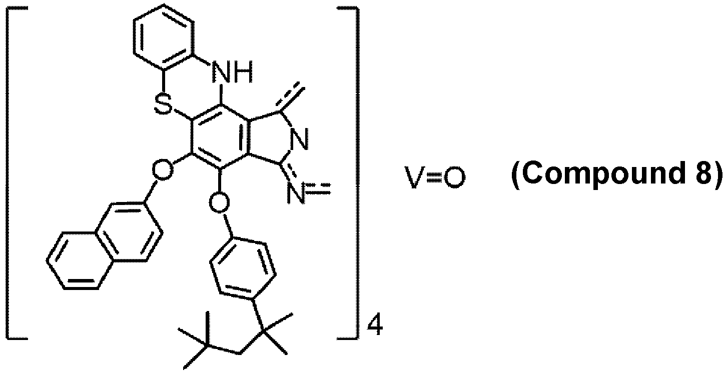

### Example 9: Phthalocyanine compound (1-3) (Compound 9) described in Example 3 of WO2014/115692

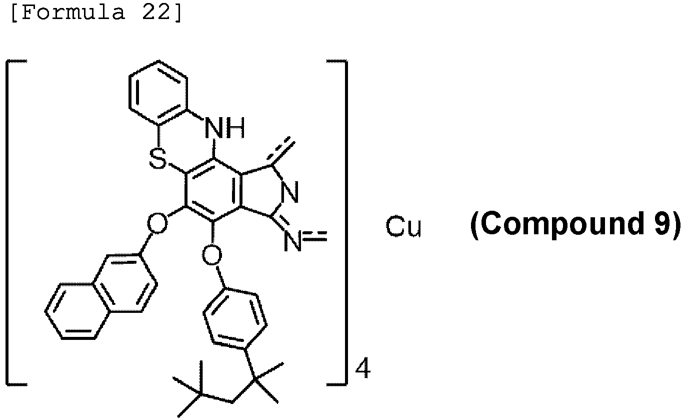

### Example 10: Phthalocyanine compound (1-4) (Compound 10) described in Example 4 of WO2014/115692

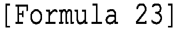

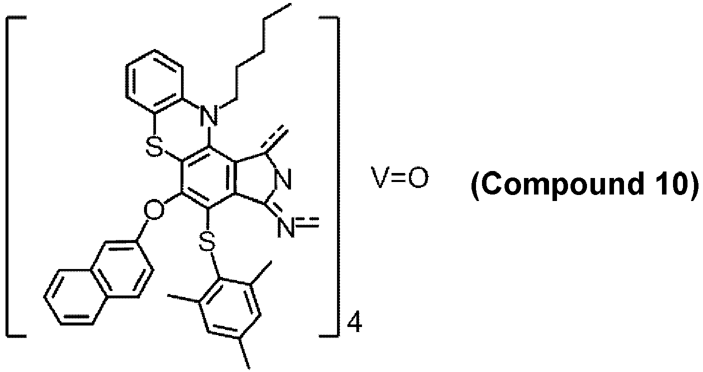

### [Formation of Optical Filter (Method 1)]

The colored curable resin compositions 1 to 10 obtained in Examples 1 to 10 were kept at 40°C for one week. Each of the kept colored curable resin compositions was applied onto a 5-cm square glass substrate (EAGLE 2000; manufactured by Corning Incorporated) by a spin coating method, and then prebaked at 100°C for 3 minutes to obtain an optical filter. Then, the optical filter was post-baked in an oven at 230°C for 20 minutes.

In the colored curable resin compositions 1 to 10 obtained in Examples 1 to 10, foreign matter was not observed in the optical filter.

### Comparative Examples 1 to 3

### [Preparation of Colored Curable Resin Compositions 1' to 3']

Colored curable resin compositions 1' to 3' were obtained in the same manner as in Example 1 except that the colorant (A) of Example 1 was replaced with the following phthalocyanine compounds (Compounds 11 to 13).

### Comparative Example 1: Phthalocyanine compound (Compound 11) described in Example 1 of Japanese Patent Laid-Open No. 2010-160380

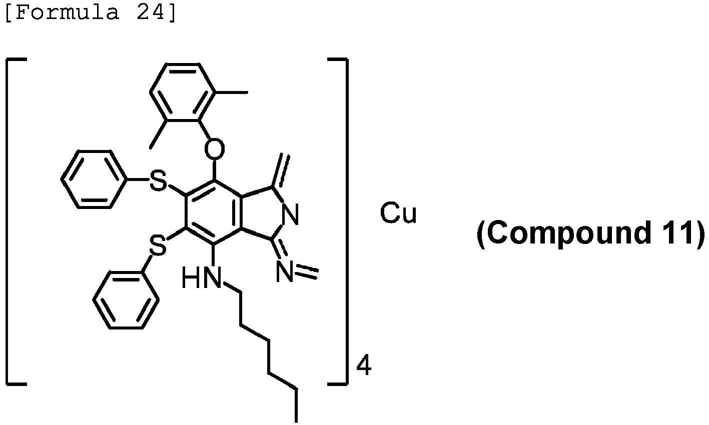

### Comparative Example 2: Phthalocyanine compound (Compound 12) described in Example 2 of Japanese Patent Laid-OpenNo. 2010-160380

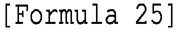

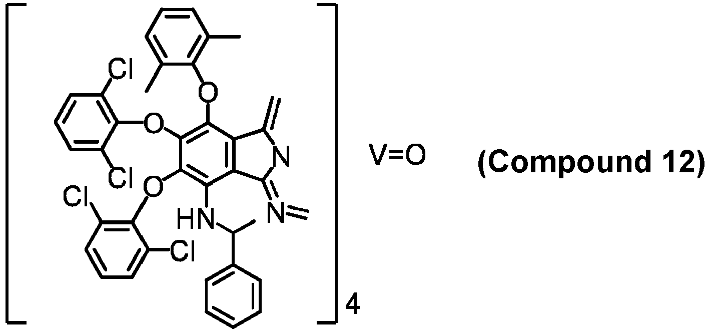

### Comparative Example 3: Phthalocyanine compound (Compound 13) described in Example 3 of Japanese Patent Laid-Open No. 2010-160380

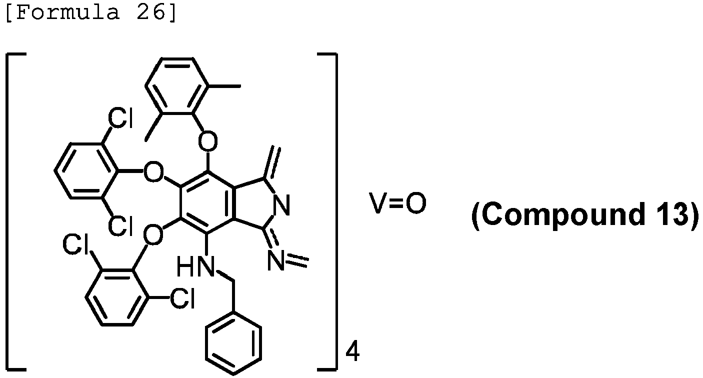

### Reference Example 1

### [Preparation of Colored Curable Resin Composition 11]

A colored curable resin composition 11 of Reference Example 1 was obtained by mixing components according to a composition shown below. The composition shown below is represented by an amount in terms of solid content except a solvent (E).

Colorant (A): Compound 1 used in Example 1: 5 parts
Resin (B): Resin (B-1) obtained in Synthesis Example 1: 15 parts
Solvent (E): (E-1) Propylene glycol monomethyl ether acetate: 20 parts
(E-2) Diethylene glycol ethyl methyl ether: 110 parts
(E-3) N-methylpyrrolidone: 100 parts
Leveling agent (F): Megafac (registered trademark) F554 (manufactured by DIC Corp.): 0.1 parts

### Reference Examples 2 to 10 and Reference Examples 1' to 3'

### [Preparation of Colored Curable Resin Compositions 12 to 20 and Colored Curable Resin Compositions 4' to 6']

Colored curable resin compositions 12 to 20 of Reference Examples 2 to 10 and colored curable resin compositions 4' to 6' of Reference Examples 1' to 3' were obtained in the same manner as in Reference Example 1 except that the colorant (A) in Reference Example 1 was replaced with the compounds 2 to 10 used in Examples 2 to 10 and the compounds 11 to 13 used in Comparative Examples 1 to 3.

### [Formation of Optical Filter (Method 2)]

The colored curable resin compositions 11 to 20 and the colored curable resin compositions 4' to 6' obtained in Reference Examples 1 to 10 and Reference Examples 1' to 3' were kept at 40°C for one week. Each of the kept colored curable resin compositions was applied onto a 5-cm square glass substrate (EAGLE XG; manufactured by Corning Incorporated) by a spin coating method so that a film thickness after post-baking was set to 0.5 µm, and then prebaked on a hot plate at 70°C for 1 minute to obtain an optical filter. Then, the optical filter was post-baked on a hot plate at 240°C for 9 minutes.

The obtained optical filter was observed with an optical microscope, to confirm whether foreign matter of 10 µm or more was observed.

As a result, foreign matter was not observed in the optical filter in the colored curable resin compositions 11 to 20 obtained in Reference Examples 1 to 10, but foreign matter was observed in the optical filter in the colored curable resin compositions 4' to 6' obtained in Reference Examples 1' to 3'.

## Claims

1. A colored curable resin composition comprising a colorant, a resin, a polymerizable compound, and a polymerization initiator,
wherein the colorant is a colorant comprising a compound represented by formula (I) or formula (II): 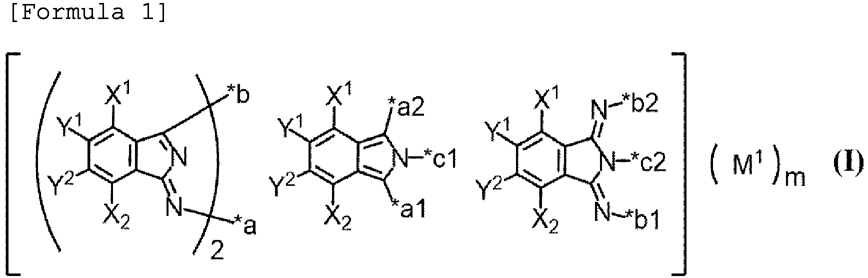 wherein:
X¹ and X² each independently represent a hydrogen atom, SR¹, or NR²R³;
Y¹ and Y² each independently represent a hydrogen atom, OR¹, or SR¹;
R¹ represents an aryl group having 6 to 20 carbon atoms or a heteroaryl group having 3 to 20 carbon atoms, and a hydrogen atom contained in the aryl group and the heteroaryl group is optionally replaced with a halogen atom or an alkoxy group having 1 to 20 carbon atoms;
R² and R³ each independently represent a hydrogen atom or an alkyl group having 1 to 10 carbon atoms; a methylene group contained in the alkyl group is optionally replaced with an oxygen atom; and R² and R³ are optionally bonded to each other to form a nitrogen atom-containing ring;
a plurality of X¹, X², Y¹, Y², R¹, R², or R³, when present in one molecule, are optionally the same or different from each other;
M¹ represents a hydrogen atom, a monovalent metal atom, a divalent metal atom, a trivalent substituted metal atom, a tetravalent substituted metal atom, or an oxidized metal atom;
when M¹ is the hydrogen atom or the monovalent metal atom, m is 2; and when M¹ is the divalent metal atom, the trivalent substituted metal atom, the tetravalent substituted metal atom, or the oxidized metal atom, m is 1;
all of *a, *a1, *a2, *b, *b1, *b2, *c1, and *c2 represent a bond; one of two *a is bonded to *a1, and the other is bonded to *a2; one of two *b is bonded to *b1, and the other is bonded to *b2; and *c1 and *c2 are bonded to M¹; 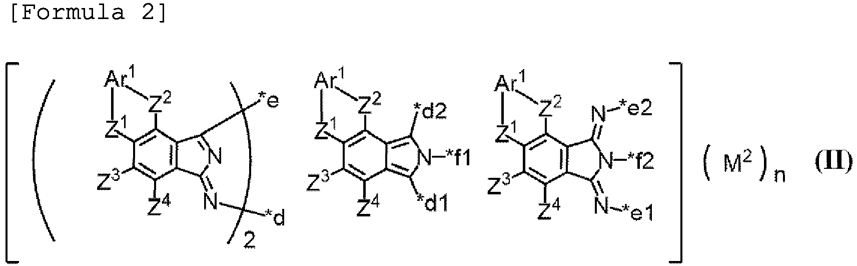 wherein:
Z¹ and Z² each independently represent an oxygen atom, a sulfur atom, or NR⁴;
R⁴ represents a hydrogen atom or an alkyl group having 1 to 10 carbon atoms, and a methylene group contained in the alkyl group is optionally replaced with an oxygen atom;
Ar¹ represents an arylene group having 6 to 20 carbon atoms or a heteroarylene group having 3 to 20 carbon atoms, and a hydrogen atom contained in the arylene group and the heteroarylene group is optionally replaced with a halogen atom or an alkoxy group having 1 to 20 carbon atoms;
Z³ and Z⁴ each independently represent a hydrogen atom, N(R⁶)₂, OR⁵, or SR⁵;
R⁵ represents an alkyl group having 1 to 20 carbon atoms, an aryl group having 6 to 20 carbon atoms, or a heteroaryl group having 3 to 20 carbon atoms; a hydrogen atom contained in the alkyl group is optionally replaced with a halogen atom; a methylene group contained in the alkyl group is optionally replaced with an oxygen atom; and a hydrogen atom contained in the aryl group and the heteroaryl group is optionally replaced with a halogen atom or an alkoxy group having 1 to 20 carbon atoms;
R⁶ represents a hydrogen atom or an alkyl group having 1 to 10 carbon atoms, wherein a hydrogen atom contained in the alkyl group is optionally replaced with an aryl group having 6 to 10 carbon atoms, and wherein a methylene group contained in the alkyl group is optionally replaced with an oxygen atom;
a plurality of Z¹, Z², Z³, Z⁴, Ar¹, R⁴, R⁵, or R⁶, when present in one molecule, are optionally the same or different from each other;
M² represents a hydrogen atom, a monovalent metal atom, a divalent metal atom, a trivalent substituted metal atom, a tetravalent substituted metal atom, or an oxidized metal atom;
when M² is the hydrogen atom or the monovalent metal atom, n is 2; and when M² is the divalent metal atom, the trivalent substituted metal atom, the tetravalent substituted metal atom, or the oxidized metal atom, n is 1; and
all of *d, *d1, *d2, *e, *e1, *e2, *f1, and *f2 represent a bond; one of two *d is bonded to *d1, and the other is bonded to *d2; one of two *e is bonded to *e1, and the other is bonded to *e2; and *f1 and *f2 are bonded to M².

2. The colored curable resin composition according to claim 1, wherein the resin is a copolymer having a structural unit derived from at least one selected from the group consisting of an unsaturated carboxylic acid and an unsaturated carboxylic anhydride and a structural unit having a cyclic ether structure having 2 to 4 carbon atoms and an ethylenically unsaturated bond.

3. An optical filter formed from the colored curable resin composition according to claim 1 or 2.

4. A solid-state image sensor comprising the optical filter according to claim 3.
